# EUROPEAN PATENT APPLICATION

(11) **EP 4 831 769 A1**
(43) Date of publication of application: **28.10.2026**
(21) Application number: 24913612.8
(22) Date of filing: 17.12.2024
(51) Int. Cl.: G06F 1/16

(54) **FLEXIBLE DISPLAY AND ELECTRONIC DEVICE COMPRISING SAME**

(30) Priority: 26.12.2023 KR 20230190851; 29.01.2024 KR 20240012968
(71) Applicant: Samsung Electronics Co., Ltd., Suwon-si, Gyeonggi-do 16677 (KR)
(72) Inventor: SONG, Hyundo, Suwon-si Gyeonggi-do 16677 (KR)
(74) Representative: Gulde & Partner
(86) International application number: PCT/KR2024/020505
(87) International publication number: WO 2025/143669

(57) **Abstract**

An electronic device according to one embodiment of the present disclosure may comprise: a housing including a first housing portion and a second housing portion; a display including a first display area, a second display area and a third area; a flexible lattice plate for supporting the second display area and the third area; and a multi-bar structure for supporting at least a portion of the flexible lattice plate corresponding to the third area of the display. Other various embodiments are possible.

## Description

### Technical Field

Various embodiments disclosed herein relate to an electronic device, for example, to a flexible display and an electronic device including the same.

### Background Art

With the remarkable development of information and communication technology and semiconductor technology, the dissemination and use of various electronic devices have been rapidly increasing. In particular, recent electronic devices have been developed to be portable and enable communication.

The term "electronic device" may refer to a device that performs a specific function according to an installed program, such as a home appliance, an electronic organizer, a portable multimedia player, a mobile communication terminal, a tablet PC, a video/audio device, a desktop/laptop computer, or a vehicle navigation system. For example, such electronic devices may output stored information as sound or an image. As the degree of integration of electronic devices increases and ultra-high-speed, large-capacity wireless communication becomes widespread, various functions may recently be incorporated in a single electronic device such as a mobile communication terminal. For example, not only a communication function but also an entertainment function such as a game, a multimedia function such as music/video playback, a communication and security function for mobile banking, or a scheduler function or an electronic wallet function may be integrated into a single electronic device. Such an electronic device is being miniaturized so that a user may conveniently carry the electronic device.

As mobile communication services are expanded to a multimedia service area, in order for a user to sufficiently use multimedia services as well as voice calls or short messages, the size of a display of an electronic device may increase.

The above information may be provided as related art for the purpose of facilitating an understanding of the disclosure. No assertion or determination is made as to whether any of the foregoing may be regarded as prior art with respect to the disclosure.

### Detailed Description of the Invention

### Technical Solution

According to an embodiment of the disclosure, an electronic device may include a housing including a first housing portion and a second housing portion configured to move with respect to the first housing portion, a display including a first display area, a second display area, and a third area, a flexible lattice plate disposed to support the second display area and the third area of the display, and a multi-bar structure disposed to support at least a portion of the flexible lattice plate corresponding to the third area of the display, and another portion of the flexible lattice plate supporting the second display area of the display may include multiple lattice layers.

According to an embodiment of the disclosure, an electronic device may include a housing including a first housing portion and a second housing portion configured to move with respect to the first housing portion, a display including a first display area disposed in the second housing portion, a second display area extending from the first display area, and a third area extending from the second display area, a first lattice plate supporting the second display area and the third area, a second lattice plate configured to support a first portion of the first lattice plate corresponding to the second display area, a third lattice plate stacked on the second lattice plate, a fourth lattice plate stacked on the third lattice plate, and a multi-bar structure configured to support a second portion of the first lattice plate corresponding to the third area.

### Brief Description of Drawings

FIG. 1 is a block diagram of an electronic device in a network environment, according to various embodiments of the disclosure.
FIG. 2 is a view illustrating a state in which a second display area of a display is accommodated inside an electronic device, according to an embodiment of the disclosure.
FIG. 3 is a view illustrating a state in which the second display area of the display is visually exposed to the outside of the electronic device, according to an embodiment of the disclosure.
FIG. 4 is an exploded perspective view illustrating an electronic device according to an embodiment of the disclosure.
FIG. 5A is a cross-sectional view taken along line A-A' of FIG. 2, according to an embodiment of the disclosure.
FIG. 5B is a cross-sectional view taken along line B-B' of FIG. 3, according to an embodiment of the disclosure.
FIG. 6A is an exploded perspective view of a display assembly according to an embodiment of the disclosure.
FIG. 6B is a cross-sectional view taken along line C-C' of FIG. 2, according to an embodiment of the disclosure.
FIG. 6C is a cross-sectional view taken along line D-D' of FIG. 3, according to an embodiment of the disclosure.
FIG. 7A is a cross-sectional view taken along line C-C' of FIG. 2, according to an embodiment of the disclosure.
FIG. 7B is a cross-sectional view taken along line D-D' of FIG. 3, according to an embodiment of the disclosure.
FIG. 8A is a rear view illustrating a support structure according to an embodiment of the disclosure.
FIG. 8B is a rear view illustrating a support structure according to an embodiment of the disclosure.
FIG. 9 is a cross-sectional view taken along line E-E' of FIG. 8B, according to an embodiment of the disclosure.
FIG. 10 is a perspective view of a support structure according to an embodiment of the disclosure.
FIG. 11 is a cross-sectional view taken along line E-E' of FIG. 8B, according to an embodiment of the disclosure.
FIG. 12 is a cross-sectional view of a support structure according to an embodiment of the disclosure.
FIG. 13 is a perspective view of a support structure according to an embodiment of the disclosure.
FIG. 14 is a perspective view of a support structure according to an embodiment of the disclosure.
FIG. 15 is a plan view of a support structure according to an embodiment of the disclosure.
FIG. 16 is a plan view illustrating a portion of the support structure according to an embodiment of the disclosure.
FIG. 17 is a plan view illustrating a portion of the support structure according to an embodiment of the disclosure.
FIG. 18 is a view illustrating a stacked relationship of a support structure according to an embodiment of the disclosure.
FIG. 19 is a view illustrating a first buffer member of a support structure according to an embodiment of the disclosure.
FIG. 20 is a view illustrating a first buffer member of a support structure according to an embodiment of the disclosure.
FIG. 21 is a perspective view illustrating a fixing member according to an embodiment of the disclosure.
FIG. 22 is a perspective view of a support structure according to an embodiment of the disclosure.
FIG. 23 is a perspective view of a support structure to which a fixing member is coupled according to an embodiment of the disclosure.
FIG. 24 is a perspective view of a support structure according to an embodiment of the disclosure.

### Mode for Carrying out the Invention

Hereinafter, embodiments of the disclosure will be described in detail with reference to the drawings so that those ordinarily skilled in the art to which the disclosure pertains may easily practice the disclosure. However, the disclosure may be implemented in various different forms and is not limited to the embodiments described herein. In connection with the description of the drawings, the same or similar reference numerals may be used for the same or similar elements. In addition, in the drawings and the related description, descriptions of well-known functions and configurations may be omitted for clarity and conciseness.

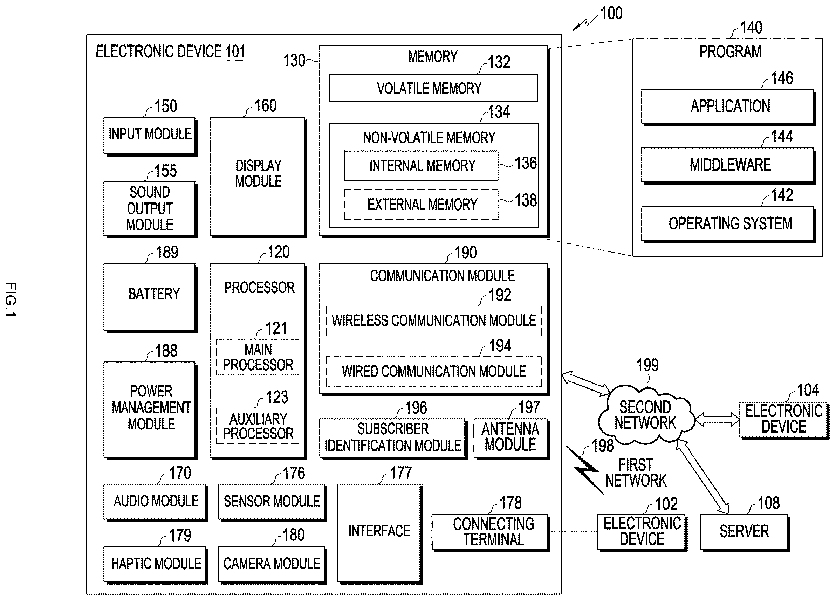

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

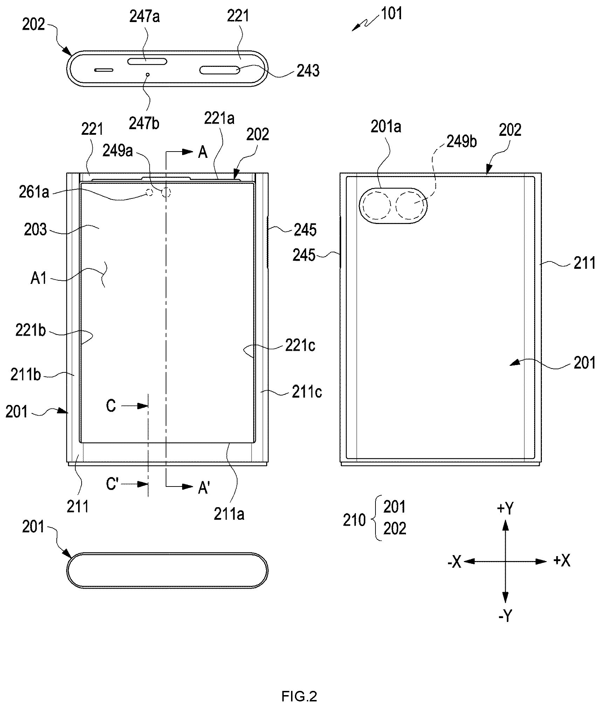

FIG. 2 is a view illustrating a state in which a second display area of a display is accommodated inside an electronic device, according to an embodiment of the disclosure. The second display area extending from a first display area may be at least partially hidden inside the electronic device on a plane different from the first display area.

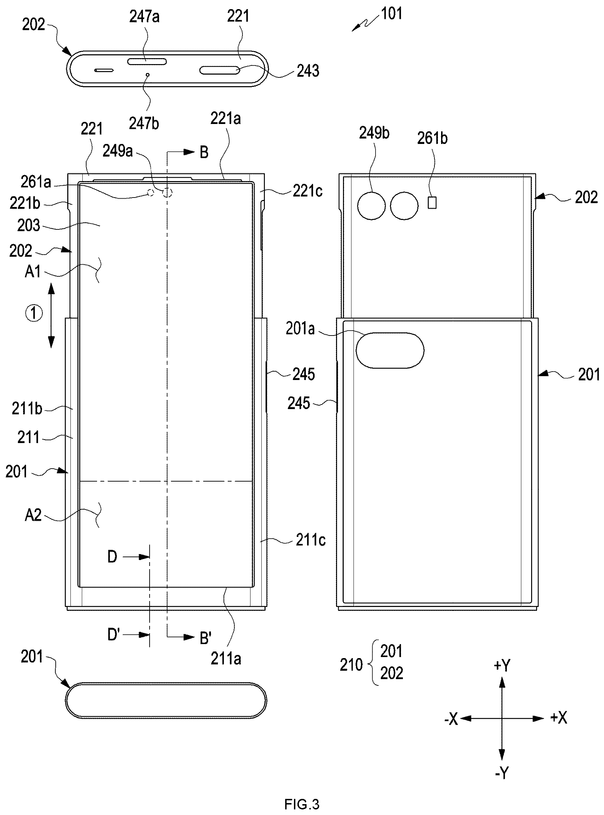

FIG. 3 is a view illustrating a state in which the second display area of the display is visually exposed to the outside of the electronic device, according to an embodiment of the disclosure. The second display area extending from the first display area may be at least partially shown to the outside of the electronic device on substantially the same plane as the first display area, based on movement of a second housing portion.

FIGS. 2 and 3 illustrate a structure in which the display 203 (e.g., a flexible display or a rollable display) extends in a length direction (e.g., the +Y direction), when viewed from the front of the electronic device 101. However, the extension direction of the display 203 is not limited to one direction (e.g., the +Y direction). For example, the extension direction of the display 203 may be changed in design to be expandable in an upward direction (the +Y direction), a rightward direction (e.g., the +X direction), a leftward direction (e.g., the -X direction), and/or a downward direction (e.g., the -Y direction).

The state illustrated in FIG. 2 may represent a state in which substantially the entirety of the second display area is hidden inside the electronic device on a plane different from the first display area. For example, the state illustrated in FIG. 2 may be referred to as a slid-in state of the electronic device 101, or a state in which the second display area A2 of the display 203 is closed.

The state illustrated in FIG. 3 may represent a state in which the area of the second display area visually exposed to the outside of the electronic device is maximized on substantially the same plane as the first display area. The state illustrated in FIG. 3 may be referred to as a slid-out state of the electronic device 101, or a state in which the second display area A2 of the display 203 is open.

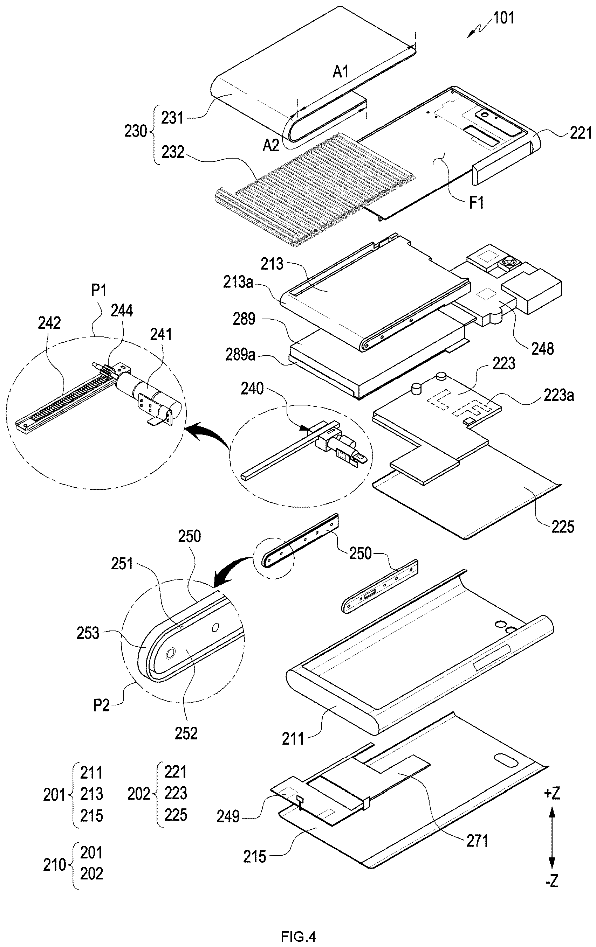

The embodiments of FIGS. 2 and 3 may be combined with the embodiment of FIG. 1 or the embodiments of FIGS. 4 to 24.

Referring to FIGS. 2 and 3, the electronic device 101 (e.g., the electronic device 101 of FIG. 1) may include a housing 210. The housing 210 may include a first housing portion 201 and a second housing portion 202 disposed to be movable relative to the first housing portion 201. In an embodiment, the electronic device 101 may be interpreted as having a structure in which the first housing portion 201 is disposed to be slidable relative to the second housing portion 202. According to an embodiment, the second housing portion 202 may be disposed to be reciprocable by a predetermined distance with respect to the first housing portion 201 in the illustrated direction, for example, in the direction indicated by arrow ① of FIG. 3. The first housing portion 201 may be referred to as a first housing, and the second housing portion 202 may be referred to as a second housing 202.

According to an embodiment, the second housing portion 202 may be referred to as a slide portion or a slide housing, and may be movable relative to the first housing portion 201. According to an embodiment, the second housing portion 202 may accommodate various electrical and electronic components such as a circuit board or a battery. When the electronic device 101 is in the slid-in state, the second housing portion 202 may be defined as being in a retracted position, and when the electronic device 101 is in the slid-out state, the second housing portion 202 may be defined as being in an extended position. For example, the second housing portion 202 may be configured to move between the retracted position and the extended position with respect to the first housing portion 201.

According to an embodiment, the slid-in state of the electronic device 101 (or the slid-out state of the electronic device 101) may transition to the slid-out state of the electronic device 101 (or the slid-in state of the electronic device 101) based on a predefined user input. For example, the slid-in state of the electronic device 101 (or the slid-out state of the electronic device 101) may transition to the slid-out state (or the slid-in state of the electronic device 101) in response to a user input to a physical button exposed through a portion of the first housing portion 201 or a portion of the second housing portion 202. For example, the slid-in state (or the slid-out state of the electronic device 101) may transition to the slid-out state (or the slid-in state of the electronic device 101) in response to a touch input to an executable object displayed in a screen display area (e.g., the first display area A1). For example, the slid-in state (or the slid-out state of the electronic device 101) may transition to the slid-out state (or the slid-in state of the electronic device 101) in response to a touch input having a contact point on a screen display area (e.g., the first display area A1) and having a pressing intensity equal to or greater than a reference intensity. For example, the slid-in state (or the slid-out state of the electronic device 101) may transition to the slid-out state (or the slid-in state of the electronic device 101) in response to a voice input received through a microphone of the electronic device 101. For example, the slid-in state (or the slid-out state of the electronic device 101) may transition to the slid-out state (or the slid-in state of the electronic device 101) in response to an external force applied to the first housing portion 201 and/or the second housing portion 202 to move the second housing portion 202 with respect to the first housing portion 201. For example, the slid-in state (or the slid-out state of the electronic device 101) may transition to the slid-out state (or the slid-in state of the electronic device 101) in response to a user input identified in an external electronic device (e.g., earbuds or a smart watch) connected to the electronic device 101. However, a method of causing a slid-in/slid-out operation of the electronic device 101 is not limited thereto.

According to an embodiment, the first housing portion 201 may accommodate a sub-circuit board electrically connected to an actuator (e.g., a motor), a speaker, a SIM socket, and/or a main circuit board. The second housing portion 202 may accommodate a main circuit board on which electrical components such as an application processor (AP) or a communication processor (CP) are mounted. According to an embodiment, the second housing portion 202 may accommodate a sub-circuit board electrically connected to an actuator, a speaker, a SIM socket, and/or a main circuit board, and the first housing portion 201 may accommodate a main circuit board on which electrical components such as an application processor (AP) or a communication processor (CP) are mounted. According to an embodiment, the sub-circuit board and the main circuit board may be disposed in the first housing portion 201 or may be disposed in the second housing portion 202.

According to an embodiment, the first housing portion 201 may include a first cover member 211 (e.g., a main case). The first cover member 211 may include a (1-1)^{th} side wall 211a, a (1-2)^{th} side wall 211b extending from the (1-1)^{th} side wall 211a, and a (1-3)^{th} side wall 211c extending from the (1-1)^{th} side wall 211a and substantially parallel to the (1-2)^{th} side wall 211b. According to an embodiment, the (1-2)^{th} side wall 211b and the (1-3)^{th} side wall 211c may be formed substantially perpendicular to the (1-1)^{th} side wall 211a.

According to an embodiment, the (1-1)^{th} side wall 211a, the (1-2)^{th} side wall 211b, and the (1-3)^{th} side wall 211c of the first cover member 211 may be formed in a shape having one side (e.g., the front face) open so as to accommodate (or surround) at least a portion of the second housing portion 202. For example, at least a portion of the second housing portion 202 may be surrounded by the first housing portion 201 and may slide in a direction parallel to a first surface (e.g., the first surface F1 of FIG. 4), for example, in the direction of arrow ① of FIG. 3, while being guided by the first housing portion 201. According to an embodiment, the (1-1)^{th} side wall 211a, the (1-2)^{th} side wall 211b, and/or the (1-3)^{th} side wall 211c of the first cover member 211 may be integrally formed. According to an embodiment, the (1-1)^{th} side wall 211a, the (1-2)^{th} side wall 211b, and/or the (1-3)^{th} side wall 211c of the first cover member 211 may be formed as separate structures to be coupled or assembled.

According to an embodiment, the first cover member 211 may be formed to surround at least a portion of the display 203. For example, at least a portion of the display 203 may be formed to be surrounded by the (1-1)^{th} side wall 211a, the (1-2)^{th} side wall 211b, and/or the (1-3)^{th} side wall 211c of the first cover member 211.

According to an embodiment, the second housing portion 202 may include a second cover member 221 (e.g., a slide plate). The second cover member 221 may have a plate shape and may include a first surface (e.g., the first surface F1 of FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a (2-1)^{th} side wall 221a, a (2-2)^{th} side wall 221b extending from the (2-1)^{th} side wall 221a, and a (2-3)^{th} side wall 221c extending from the (2-1)^{th} side wall 221a and substantially parallel to the (2-2)^{th} side wall 221b. According to an embodiment, the (2-2)^{th} side wall 221b and the (2-3)^{th} side wall 221c may be formed substantially perpendicular to the (2-1)^{th} side wall 221a.

According to an embodiment, as the second housing portion 202 moves in the first direction (e.g., direction ① of FIG. 3) parallel to the (2-2)^{th} side wall 221b or the (2-3)^{th} side wall 221c, the electronic device 101 may define a slid-in state and a slid-out state. In the slid-in state of the electronic device 101, the second housing portion 202 may be positioned at a first distance from the (1-1)^{th} side wall 211a of the first housing portion 201, and in the slid-out state of the electronic device 101, the second housing portion 202 may move to be positioned at a second distance greater than the first distance from the (1-1)^{th} side wall 211a of the first housing portion 201. In an embodiment, in the slid-in state of the electronic device 101, the first housing portion 201 may be formed to surround portions of the (2-2)^{th} side wall 221b and the (2-3)^{th} side wall 221c.

According to an embodiment, the electronic device 101 may have an intermediate state between the slid-in state of FIG. 2 (e.g., a fully closed state) and the slid-out state of FIG. 3 (e.g., a fully opened state). In the intermediate state of the electronic device 101, the distance between the (1-1)^{th} side wall 211a and the (2-1)^{th} side wall 221a may be smaller than the distance between the (1-1)^{th} side wall 211a and the (2-1)^{th} side wall 221a in the fully opened state of the electronic device 101, and may be greater than the distance between the (1-1)^{th} side wall 211a and the (2-1)^{th} side wall 221a in the fully closed state of the electronic device 101. According to an embodiment, as at least a portion of the display 203 slides in the intermediate state of the electronic device 101, an area exposed to the outside may vary. For example, in the intermediate state of the electronic device 101, the ratio of the width of the display 203 (e.g., a length in the X direction) to the height of the display 203 (e.g., a length in the Y direction) and/or the distance between the (1-1)^{th} side wall 211a and the (2-1)^{th} side wall 221a may be changed based on slide movement of the electronic device 101.

According to an embodiment, the electronic device 101 may include a display 203, a key input device 245, a connector hole 243, audio modules 247a and 247b, or camera modules 249a and 249b. According to an embodiment, the electronic device 101 may further include an indicator (e.g., an LED device) or various sensor modules.

According to various embodiments, the display 203 may be configured such that the size of a portion visible from the front side of the housing 210 is changed based on slide movement of the second housing portion 202. According to an embodiment, the display 203 may include a first display area A1 and a second display area A2 configured to be exposed to the outside of the electronic device 101 based on slide movement of the second housing portion 202.

According to an embodiment, as the second housing portion 202 moves between the retracted position and the extended position with respect to the first housing portion 201, the size of the display 203 shown toward an outer front face side of the electronic device 101 may vary. For example, when the second housing portion 202 is positioned at the retracted position (e.g., FIG. 2) with respect to the first housing portion 201, the size (or area) of the display 203 shown toward the outer front face side of the electronic device 101 may be substantially minimized. In addition, when the second housing portion 202 is positioned at the extended position (e.g., FIG. 3) with respect to the first housing portion 201, the size (or area) of the display 203 shown toward the outer front face side of the electronic device 101 may be substantially maximized.

According to an embodiment, the first display area A1 may be disposed on the second housing portion 202. For example, the first display area A1 may be disposed on the second cover member 221 of the second housing portion 202. According to an embodiment, the second display area A2 may extend from the first display area A1, and as the second housing portion 202 slides with respect to the first housing portion 201, the second display area A2 may be accommodated inside the first housing portion 201 or may be visually exposed to the outside of the electronic device 101. According to an embodiment, as the electronic device 101 transitions from the slid-in state to the slid-out state, the display 203 may expand in the downward direction of the electronic device 101 (e.g., the -Y direction). For example, in the slid-out state of the electronic device 101, the second display area A2 may be visually exposed below the display 203 (e.g., in the -Y direction). According to an embodiment, as the electronic device 101 transitions from the slid-in state to the slid-out state, the display 203 may expand in the upward direction of the electronic device 101 (e.g., the +Y direction). For example, in the slid-out state of the electronic device 101, the second display area A2 may be visually exposed above the display 203 (e.g., in the +Y direction).

According to an embodiment, the second display area A2 may move substantially along an area of the first housing portion 201 (e.g., the guide rail 250 of FIG. 4), and may be accommodated in a space located inside the first housing portion 201 or may be exposed to the outside of the electronic device 101. According to an embodiment, the second display area A2 may move based on slide movement of the second housing portion 202 in the first direction (e.g., the direction indicated by arrow ①). For example, while the second housing portion 202 slides, a portion of the second display area A2 may be deformed into a curved shape at a position corresponding to the curved surface 213a of the first housing portion 201.

According to an embodiment, when viewed from above the second cover member 221 (e.g., the front cover) (e.g., in the +Z direction or from the front face side of the electronic device), as the electronic device 101 transitions from the slid-in state to the slid-out state (e.g., as the second housing portion 202 slides so as to extend with respect to the first housing portion 201), the second display area A2 may gradually be exposed to the outside of the first housing portion 201 and may form substantially the same plane together with the first display area A1. According to an embodiment, the display 203 may be coupled to or disposed adjacent to a touch sensing circuit, a pressure sensor capable of measuring an intensity (pressure) of a touch, and/or a digitizer configured to detect a magnetic-field-type stylus pen. According to an embodiment, regardless of whether the electronic device 101 is in the slid-in state or the slid-out state, a portion of the exposed second display area A2 may be positioned on a portion of the first housing portion (e.g., the curved surface 213a of FIG. 4), and a portion of the second display area A2 may maintain a curved shape at a position corresponding to the curved surface 213a.

According to an embodiment, the key input device 245 may be located in an area of the housing 210 (e.g., the first housing portion 201 and/or the second housing portion 202). Depending on an external appearance and a use state, the illustrated key input device 245 may be omitted, or the electronic device 101 may be designed to include additional key input device(s). According to an embodiment, the electronic device 101 may include a key input device that is not illustrated, for example, a home key button or a touch pad disposed around the home key button. According to an embodiment, at least a portion of the key input device 245 may be disposed on the (1-1)^{th} side wall 211a, the (1-2)^{th} side wall 211b, and/or the (1-3)^{th} side wall 211c of the first housing portion 201. According to an embodiment, at least a portion of the key input device 245 may be disposed on the (2-1)^{th} side wall 221a, the (2-2)^{th} side wall 221b, and/or the (2-3)^{th} side wall 221c of the second housing portion 202.

According to an embodiment, the connector hole 243 may be omitted, and may accommodate a connector (e.g., a USB connector) configured to transmit and receive power and/or data to and from an external electronic device. According to an embodiment, the electronic device 101 may include a plurality of connector holes 243, and some of the plurality of connector holes 243 may function as connector holes configured to transmit and receive an audio signal to and from an external electronic device. In the illustrated embodiment, the connector hole 243 is positioned in the second housing portion 202, but the disclosure is not limited thereto, and the connector hole 243 or a connector hole that is not illustrated may be positioned in the first housing portion 201.

According to an embodiment, the audio modules 247a and 247b may include at least one speaker hole 247a or at least one microphone hole 247b. One of the speaker holes 247a may be provided as a receiver hole for a voice call, and another one of the speaker holes 247a may be provided as an external speaker hole. The electronic device 101 may include a microphone for acquiring sound, and the microphone may acquire sound outside the electronic device 101 through the microphone hole 247b. According to an embodiment, the electronic device 101 may include a plurality of microphones to detect a direction of sound. According to an embodiment, the electronic device 101 may include an audio module in which the speaker hole 247a and the microphone hole 247b are implemented as a single hole, or may include a speaker without the speaker hole 247a (e.g., a piezo speaker). According to an embodiment, the speaker hole 247a and the microphone hole 247b may be positioned in the first housing portion 201 and/or the second housing portion 202.

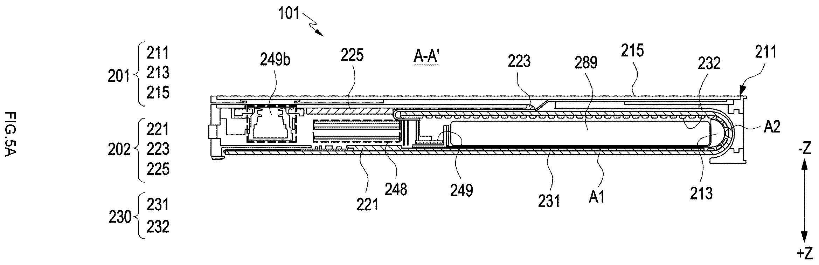

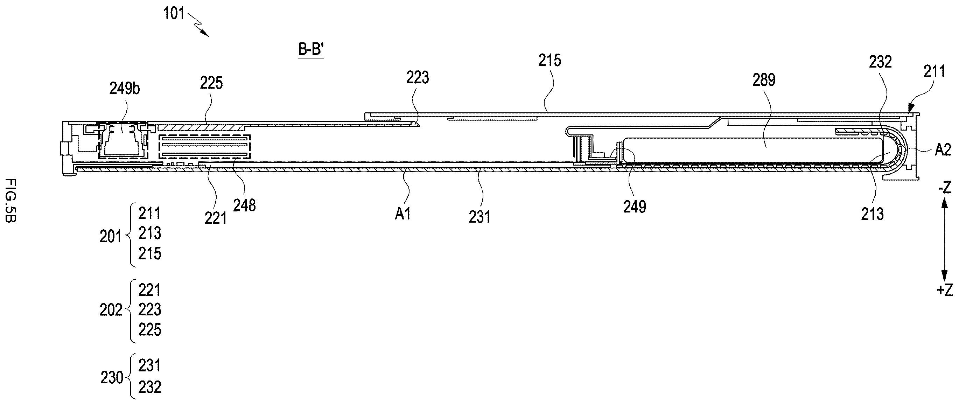

According to an embodiment, the camera modules 249a and 249b may include a first camera module 249a (e.g., a front camera) and a second camera module 249b (e.g., a rear camera) (e.g., the second camera module 249b of FIGS. 5A and 5B). According to an embodiment, the electronic device 101 may include at least one of a wide-angle camera, a telephoto camera, or a close-up camera, and may measure a distance to a subject by including an infrared projector and/or an infrared receiver. The camera modules 249a and 249b may include one or more lenses, an image sensor, and/or an image signal processor. The first camera module 249a may be disposed to be oriented in the same direction as the display 203. For example, the first camera module 249a may be disposed around the first display area A1 or in an area overlapping the display 203, and, when disposed in the area overlapping the display 203, may capture a subject through the display 203. According to an embodiment, the first camera module 249a may not be visually exposed in a screen display area (e.g., the first display area A1), and may include an under-display camera (UDC). According to an embodiment, the second camera module 249b may capture a subject in a direction opposite to the first display area A1. According to an embodiment, the first camera module 249a and/or the second camera module 249b may be disposed on the second housing portion 202. According to an embodiment, a plurality of second camera modules 249b may be formed and provide various arrangements. For example, the plurality of second camera modules 249b may be arranged along the width direction (the X-axis direction), which is substantially perpendicular to the slide movement direction of the electronic device 101 (e.g., the Y-axis direction). According to an embodiment, the plurality of second camera modules 249b may be arranged along the slide movement direction of the electronic device 101 (e.g., the Y-axis direction). As another example, the plurality of second camera modules 249b may be arranged along N * M rows and columns like a matrix.

According to an embodiment, the second camera module 249b may not be visually exposed to the outside of the electronic device 101 in the slid-in state of the electronic device 101, and may capture the outside of the electronic device 101 in the slid-out state of the electronic device 101. According to an embodiment, the second camera module 249b may capture the outside of the electronic device 101 in the slid-in state and/or the slid-out state of the electronic device 101. For example, at least a portion of the housing 210 (e.g., the first rear surface plate 215 and/or the second rear surface plate 225 of FIG. 4) may be substantially transparent, and the second camera module 249b may capture the outside of the electronic device 101 through the first rear surface plate 215 and/or the second rear surface plate 225. According to an embodiment, the second camera module 249b may be visually exposed to the outside of the electronic device 101 in the slid-in state and the slid-out state of the electronic device 101, and may capture the exterior. For example, the first housing portion 201 (e.g., the first rear surface plate 215 of FIG. 4) may include an opening 201a for the second camera module 249b.

According to an embodiment, an indicator (not illustrated) of the electronic device 101 may be disposed in the first housing portion 201 or the second housing portion 202, and may provide state information of the electronic device 101 as a visual signal by including a light-emitting diode. The sensor modules 261a and 261b of the electronic device 101 may generate an electrical signal or a data value corresponding to an operating state inside the electronic device 101 or an environmental state outside the electronic device 101. The sensor modules 261a and 261b may include a proximity sensor, a fingerprint sensor, and/or a biometric sensor (e.g., an iris/face recognition sensor or an HRM sensor). In an embodiment, the sensor modules 261a and 261b may further include at least one of a gesture sensor, a gyro sensor, a barometric sensor, a magnetic sensor, an acceleration sensor, a grip sensor, a color sensor, an IR (infrared) sensor, a temperature sensor, a humidity sensor, or an illuminance sensor. According to an embodiment, the sensor modules 261a and 261b may be disposed in the first housing portion 201 and/or the second housing portion 202. For example, the sensor modules 261a and 261b may include a first sensor module 261a disposed on the front face of the electronic device 101 (e.g., a proximity sensor or an illuminance sensor) and/or a second sensor module 261b disposed on the rear face of the electronic device 101 (e.g., an HRM (heart rate monitoring) sensor).

FIG. 4 is an exploded perspective view illustrating an electronic device according to an embodiment of the disclosure.

FIG. 5A is a cross-sectional view taken along line A-A' of FIG. 2, according to an embodiment of the disclosure.

FIG. 5B is a cross-sectional view taken along line B-B' of FIG. 3, according to an embodiment of the disclosure.

Referring to FIG. 4, FIG. 5A, and/or FIG. 5B, the electronic device 101 (e.g., the electronic device 101 of FIGS. 1 to 3) may include a housing 210, a first housing portion 201, a second housing portion 202, a display assembly 230, and a driving structure 240. The configurations of the first housing portion 201, the second housing portion 202, and the display assembly 230 of FIG. 4, FIG. 5A, and/or FIG. 5B may be wholly or partially identical to the configurations of the housing 210, the first housing portion 201, the second housing portion 202, and the display 203 of FIG. 2 and/or FIG. 3.

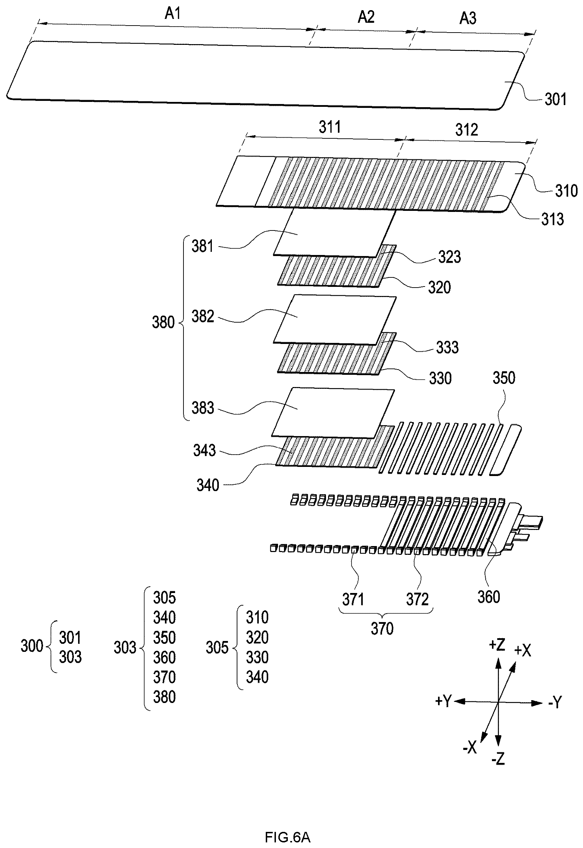

The embodiments of FIGS. 4 to 5B may be combined with the embodiments of FIGS. 1 to 3 or the embodiments of FIGS. 6A to 24.

According to an embodiment, the housing 210 may include a first housing portion 201 or a second housing portion 202 movably coupled with respect to the first housing portion 201.

According to an embodiment, the first housing portion 201 may include a first cover member 211 (e.g., the first cover member 211 of FIGS. 2 and 3), a frame 213, and a first rear surface plate 215.

According to an embodiment, the first cover member 211 may accommodate at least a portion of the frame 213, and may accommodate a component (e.g., a battery 289) positioned in the frame 213. According to an embodiment, the first cover member 211 may be configured to surround at least a portion of the second housing portion 202. According to an embodiment, the first cover member 211 may protect components (e.g., the second circuit board 249 and the frame 213) positioned in the first housing portion 201 from an external impact. According to an embodiment, the second circuit board 249 electrically connected to an electrical component (e.g., an actuator, a speaker, a SIM socket, and/or the first circuit board 248) may be connected to the first cover member 211.

According to an embodiment, an outer surface of the first cover member 211 (e.g., the surface oriented in the -Z direction of FIG. 4) may be covered, at least partially, by the first rear surface plate 215. For example, the outer surface of the first cover member 211 may be disposed to face the first rear surface plate 215. An antenna member 271 may be disposed on the outer surface of the first cover member 211. The antenna member 271 may be disposed between the first cover member 211 and the first rear surface plate 215.

According to an embodiment, the frame 213 and/or the battery 289 may be disposed on an inner surface of the first cover member 211 (e.g., the surface oriented in the +Z direction of FIG. 4). The inner surface of the first cover member 211 (e.g., the surface oriented in the +Z direction of FIG. 4) may face the frame 213 and/or the battery 289.

According to an embodiment, as the antenna member 271 is disposed in the first housing portion 201 and/or the first cover member 211 and the first circuit board 248 is disposed in the second housing portion 202 and/or the second cover member 221, the relative position of the first circuit board 248 with respect to the antenna member 271 may vary. For example, when the second housing portion 202 moves relative to the first housing portion 201, the first circuit board 248 may move relative to the antenna member 271.

According to an embodiment, the frame 213 may be connected to the first cover member 211. For example, the frame 213 may be connected to the first cover member 211, and the second housing portion 202 may move relative to the first cover member 211 and/or the frame 213. According to an embodiment, the frame 213 may accommodate a battery 289. For example, the frame 213 may include a groove configured to accommodate the battery 289. The frame 213 may be connected to a battery cover 289a and may surround at least a portion of the battery 289 together with the battery cover 289a. According to an embodiment, the frame 213 may include a curved portion 213a facing the display assembly 230.

According to an embodiment, the first rear surface plate 215 may substantially form at least a portion of an external appearance of the first housing portion 201 or the electronic device 101. For example, the first rear surface plate 215 may be coupled to the outer surface of the first cover member 211. According to an embodiment, the first rear surface plate 215 may provide a decorative effect in the external appearance of the electronic device 101. The first rear surface plate 215 may be made using at least one of metal, glass, synthetic resin, or ceramic.

According to an embodiment, the second housing portion 202 may include a second cover member 221 (e.g., the second cover member 221 of FIGS. 2 and 3), a rear cover 223, and a second rear surface plate 225.

According to an embodiment, the second cover member 221 may be connected to the first housing portion 201 through a guide rail 250, and may linearly reciprocate in one direction (e.g., the direction of arrow ① of FIG. 3) while being guided by the guide rail 250.

According to various embodiments, the second cover member 221 may support at least a portion of the display 231. For example, the second cover member 221 may include a first surface F1, and the first display area A1 of the display 231 may be located substantially on the first surface F1 and may be maintained in a flat plate shape. According to an embodiment, the second cover member 221 may be formed of a metal material and/or a non-metal material (e.g., a polymer material). According to an embodiment, the first circuit board 248 accommodating electronic components (e.g., the processor 120 and/or the memory 130 of FIG. 1) may be connected to the second cover member 221. According to an embodiment, the second cover member 221 may protect components (e.g., the first circuit board 248 and the rear cover 223) positioned in the second housing portion 202 from an external impact.

According to an embodiment, the rear cover 223 may protect a component (e.g., the first circuit board 248) positioned on the second cover member 221. For example, the rear cover 223 may be connected to the second cover member 221 and may be formed to surround at least a portion of the first circuit board 248. According to an embodiment, the rear cover 223 may include an antenna pattern (e.g., at least one antenna element 223a) configured to communicate with an external electronic device. For example, when the rear cover 223 is formed as an injection-molded article of a dielectric material (e.g., an antenna carrier), the at least one antenna element 223a may be disposed on an outer surface of the rear cover 223 (e.g., the surface oriented in the -Z-axis direction). For example, the at least one antenna element 223a may include a laser direct structuring (LDS) antenna pattern formed on the outer surface of the rear cover 223. For example, the at least one antenna element 223a may be formed to be embedded during injection molding of the rear cover 223. For example, the at least one antenna element 223a may be configured to transmit or receive a wireless signal in a predetermined frequency band (e.g., a legacy band) by being electrically connected to a wireless communication circuit (e.g., the wireless communication module 192 of FIG. 1) disposed on the first circuit board 248.

According to an embodiment, the second rear surface plate 225 may substantially form at least a portion of an external appearance of the second housing portion 202 or the electronic device 101. For example, the second rear surface plate 225 may be coupled to the outer surface of the second cover member 221. According to an embodiment, the second rear surface plate 225 may provide a decorative effect in the external appearance of the electronic device 101. The second rear surface plate 225 may be made using at least one of metal, glass, synthetic resin, or ceramic.

According to various embodiments, the display assembly 230 may include a display 231 (e.g., the display 203 of FIG. 2 and/or FIG. 3) and a multi-bar structure 232 supporting the display 231. According to an embodiment, the display 231 may be referred to as a flexible display, a foldable display, and/or a rollable display. According to an embodiment, the first display area A1 of the display 231 may be supported by a rigid body, and the second display area A2 may be supported by a bendable structure. For example, the first display area A1 may be supported by the first surface F1 of the second cover member 221 or a plate not illustrated. The second display area A2 may be supported by the multi-bar structure 232.

According to an embodiment, the multi-bar structure 232 may be connected or attached to at least a portion of the display 231 (e.g., the second display area A2). According to an embodiment, as the second housing portion 202 slides, the multi-bar structure 232 may move with respect to the first housing portion 201. In the slid-in state of the electronic device 101 (e.g., FIG. 2), the multi-bar structure 232 may be mostly accommodated inside the first housing portion 201, and may be positioned between the first cover member 211 and the second cover member 221. According to an embodiment, at least a portion of the multi-bar structure 232 may move corresponding to the curved surface 213a positioned at an edge of the frame 213. According to an embodiment, the multi-bar structure 232 may be referred to as a display support member or a support structure, and may have a form of one bendable plate.

According to an embodiment, the driving structure 240 may relatively move the second housing portion 202 with respect to the first housing portion 201. For example, the driving structure 240 may include an actuator 241 configured to generate a driving force for slide movement of the second housing portion 202 with respect to the first housing portion 201. The driving structure 240 may include a gear 244 (e.g., a pinion) connected to the actuator 241 and a rack 242 configured to be engaged with the gear. Referring to FIG. 4, components of the driving structure 240 (e.g., the actuator 241, the rack 242, and the gear 244) inverted (e.g., oriented in the -Z axis) are shown within the circle P1.

According to an embodiment, a housing in which the rack 242 is positioned and a housing in which the actuator 241 is positioned may be different from each other. According to an embodiment, the actuator 241 may be connected to the first housing portion 201, and the rack 242 may be connected to the second housing portion 202. According to an embodiment, the actuator 241 may be connected to the second housing portion 202, and the rack 242 may be connected to the first housing portion 201.

According to an embodiment, the actuator 241 may be controlled by a processor (e.g., the processor 120 of FIG. 1). For example, the processor 120 may include an actuator driver circuit and may be configured to transmit, to the actuator 241, a pulse width modulation (PWM) signal for controlling a speed of the actuator 241 and/or a torque of the actuator 241. According to an embodiment, the actuator 241 may be electrically connected, using a flexible printed circuit board, to a processor (e.g., the processor 120 of FIG. 1) positioned on a circuit board (e.g., the first circuit board 248 of FIG. 4).

According to an embodiment, the second housing portion 202 may accommodate a first circuit board 248 (e.g., a main circuit board). According to an embodiment, a processor, memory, and/or an interface may be mounted on the first circuit board 248. The processor may include, for example, one or more of a central processing unit, an application processor, a graphics processing unit, an image signal processor, a sensor hub processor, or a communication processor. According to various embodiments, the first circuit board 248 may include a radio frequency cable (FRC) of a flexible printed circuit board type. The first circuit board 248 may be disposed on at least a portion of the second cover member 221 and may be electrically connected to an antenna module (e.g., the antenna module 197 of FIG. 1) and a communication module (e.g., the communication module 190 of FIG. 1).

According to an embodiment, the first circuit board 248 may move together with the second housing portion 202 when the second housing portion 202 moves relative to the first housing portion 201.

According to an embodiment, the memory may include, for example, volatile memory or non-volatile memory.

According to an embodiment, the interface may include, for example, a high-definition multimedia interface (HDMI), a universal serial bus (USB) interface, an SD card interface, and/or an audio interface. The interface may, for example, electrically or physically connect the electronic device 101 to an external electronic device, and may include a USB connector, an SD card/an MMC connector, or an audio connector.

According to an embodiment, the electronic device 101 may include a second circuit board 249 (e.g., a sub-circuit board) spaced apart from the first circuit board 248 (e.g., a main circuit board) in the first housing portion 201. The second circuit board 249 may be electrically connected to the first circuit board 248 through a flexible board. The second circuit board 249 may be electrically connected to electrical components disposed in an end area of the electronic device 101, such as the battery 289 or the speaker and/or the SIM socket, so as to transmit signals and power. According to an embodiment, the second circuit board 249 may accommodate the antenna member 271 (e.g., a coil) or may be connected to the antenna member 271. The antenna member 271 may include a multi-function coil (MFC) antenna including a wireless charging antenna for a wireless charging function, a near-field communication (NFC) antenna for an NFC function, and/or a magnetic secure transmission (MST) antenna for an electronic payment function. For example, the battery 289 may receive power from an external electronic device using the antenna member 271 for wireless charging. As another example, the battery 289 may transmit power to an external electronic device using the antenna member 271 for wireless charging.

According to an embodiment, the battery 289 may be a device for supplying power to at least one component of the electronic device 101 and may include a non-rechargeable primary battery, a rechargeable secondary battery, or a fuel cell. The battery 289 may be integrally disposed inside the electronic device 101, or may be detachably disposed with respect to the electronic device 101. According to an embodiment, the battery 289 may be formed as a single integrated battery or may include a plurality of detachable batteries. According to an embodiment, the battery 289 may be positioned in the frame 213. For example, the battery 289 may be surrounded by the frame 213 and the battery cover 289a. According to an embodiment, the multi-bar structure 232 may be positioned in the second housing portion 202 and may slide together with the second housing portion 202.

According to an embodiment, the guide rail 250 may guide movement of the multi-bar structure 232. For example, the multi-bar structure 232 may slide along a slit 251 formed in the guide rail 250. According to an embodiment, the guide rail 250 may be connected to the first housing portion 201. For example, the guide rail 250 may be connected to the first cover member 211 and/or the frame 213. According to an embodiment, the slit 251 may be referred to as a groove or a recess formed in an inner side surface of the guide rail 250. Referring to FIG. 4, an enlarged view of the guide rail 250 is shown within circle P2.

According to an embodiment, the guide rail 250 may provide a force to the multi-bar structure 232 based on driving of the actuator 241.

According to an embodiment, when the electronic device 101 transitions from the slid-in state to the slid-out state, at least a portion of the second housing portion 202 may slide so as to be exposed to the exterior from the first housing portion 201 through the driving of the actuator 241. For example, the gear 244 may rotate in a first rotation direction based on the driving of the actuator 241. As the rack 242 is fixed on the second cover member 221 of the second housing portion 202, the second housing portion 202 may slide so as to be exposed to the outside of the first housing portion 201 based on slide movement of the rack 242 toward the slid-out direction.

According to an embodiment, when the electronic device 101 transitions from the slid-in state to the slid-out state, an inner portion 252 of the guide rail 250 may provide a force to the multi-bar structure 232. The multi-bar structure 232 provided with the force may move along the slit 251 of the guide rail 250, and the second housing portion 202 may slide so as to extend with respect to the first housing portion 201. At least a portion of the display assembly 230 accommodated between the first cover member 211 and the frame 213 may expand forward.

According to an embodiment, when the electronic device 101 transitions from the slid-out state to the slid-in state, at least a portion of the second housing portion 202 may slide so as to be inserted into an inner side of the first housing portion 201 through driving of the actuator 241. For example, the gear 244 may rotate in a second rotation direction opposite to the first rotation direction based on the driving of the actuator 241. As the rack 242 is fixed on the second cover member 221 of the second housing portion 202, the second housing portion 202 may slide so as to enter the inner side of the first housing portion 201 based on slide movement of the rack 242 toward the slid-in direction.

According to an embodiment, when the electronic device 101 transitions from the slid-out state to the slid-in state, an outer portion 253 of the guide rail 250 may provide a force to the bent multi-bar structure 232. The multi-bar structure 232 provided with the force may move along the slit 251 of the guide rail 250, and at least a portion of the second housing portion 202 may slide so as to be accommodated in the first housing portion 201. At least a portion of the display assembly 230 may be accommodated between the first cover member 211 and the frame 213.

According to an embodiment, the electronic device 101 may be configured to stop at a predetermined intermediate state between the slid-in state and the slid-out state by controlling the driving of the actuator 241 (a free-stop function). According to an embodiment, in a state in which no driving force is provided to the actuator 241, the electronic device 101 may transition to the slid-in state, the intermediate state, or the slid-out state through a user manipulation.

Referring to FIG. 5A, in the slid-in state of the electronic device 101, at least a portion of the second housing portion 202 may be disposed to be accommodated in the first housing portion 201. As the second housing portion 202 is disposed to be accommodated in the first housing portion 201, the overall size of the electronic device 101 may decrease. According to an embodiment, when the second housing portion 202 is accommodated in the first housing portion 201, the size of the display 231 visually exposed may be minimized. For example, when the second housing portion 202 is fully accommodated in the first housing portion 201, the first display area A1 of the display 231 may be visually exposed, and at least a portion of the second display area A2 (e.g., a portion oriented in the -Z axis) may be disposed between the battery 289 and the first rear surface plate 215.

Referring to FIG. 5B, when the electronic device 101 is in the slid-out state, at least a portion of the second housing portion 202 may protrude from the first housing portion 201. As the second housing portion 202 protrudes from the first housing portion 201, the overall size of the electronic device 101 may increase. According to an embodiment, when the second housing portion 202 protrudes from the first housing portion 201, at least a portion of the second display area A2 of the display 231 may be visually exposed to the outside of the electronic device 101 together with the first display area A1.

FIG. 6A is an exploded perspective view of a display assembly according to an embodiment of the disclosure.

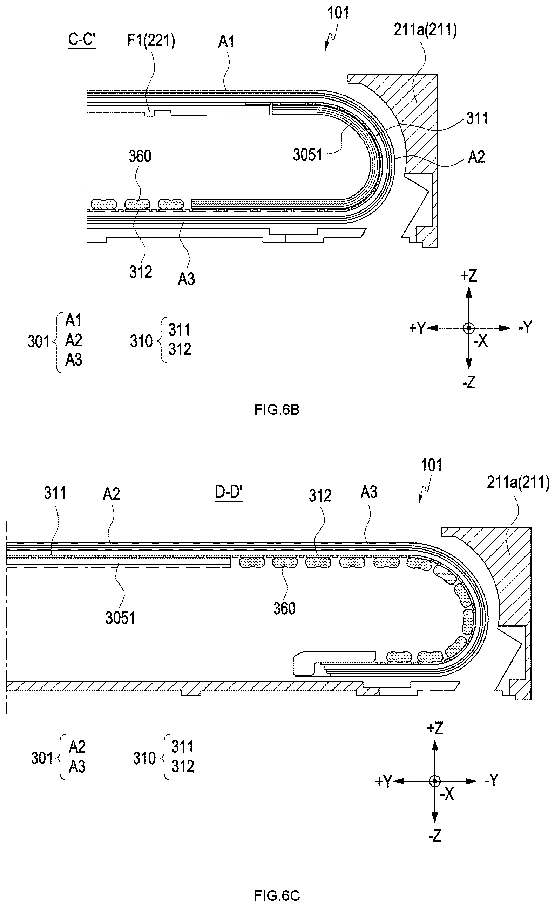

FIG. 6B is a cross-sectional view taken along line C-C' of FIG. 2, according to an embodiment of the disclosure.

FIG. 6C is a cross-sectional view taken along line D-D' of FIG. 3, according to an embodiment of the disclosure.

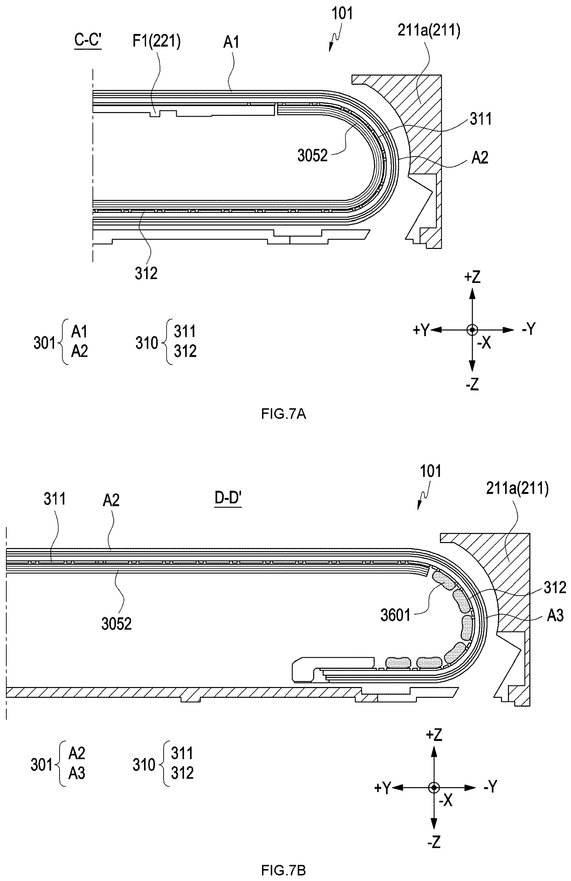

FIG. 7A is a cross-sectional view taken along line C-C' of FIG. 2, according to an embodiment of the disclosure.

FIG. 7B is a cross-sectional view taken along line D-D' of FIG. 3, according to an embodiment of the disclosure.

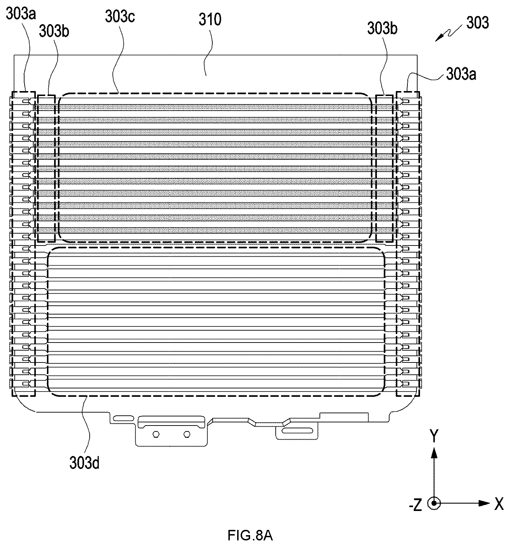

The embodiments of FIGS. 6A to 7B may be combined with the embodiments of FIGS. 1 to 5B or the embodiments of FIGS. 8A to 24.

Referring to FIGS. 6A to 7B, the electronic device 101 (e.g., the electronic device 101 of FIG. 1 or the electronic device 101 of FIGS. 2 to 5B) may include a display assembly 300.

The configuration of the display assembly 300 of FIGS. 6A to 7B may be partially or entirely the same as the configuration of the display assembly 230 of FIGS. 4 to 5B.

FIG. 6A is an exploded perspective view illustrating a state in which the display assembly 300 is unfolded.

According to an embodiment, the display assembly 300 may include a display 301 (e.g., the display 231 of FIG. 4) or a support structure 303.

According to an embodiment, the display 301 may include a first display area A1 (e.g., the first display area A1 of FIGS. 4 to 5B), a second display area A2 (e.g., the second display area A2 of FIGS. 4 to 5B), and/or a third area A3.

According to an embodiment, the support structure 303 may be configured to support the display 301. For example, the support structure 303 may be configured to generally support at least a portion of the second display area A2 and/or at least a portion of the third area A3. For example, the support structure 303 may be configured to support a rear surface of the second display area A2 (e.g., a surface oriented the -Z direction of FIG. 6A) and a rear surface of the third area A3 (e.g., a surface oriented in the -Z direction of FIG. 6A). According to an embodiment, the support structure 303 may be defined and/or interpreted as supporting a portion of the first display area A1, the entirety of the second display area A2, and the entirety of the third area A3.

According to an embodiment, the display 301 may include a first display area A1, a second display area A2, and/or a third area A3. The second display area A2 may be connected to the first display area A1. The third area A3 may be connected to the second display area A2. The third area A3 may be defined and/or referred to as a third display area. The third area A3 may be defined and/or interpreted as at least a portion of the second display area A2, but is not limited thereto.

According to an embodiment, the second display area A2 may extend from the first display area A1. The second display area A2 may be mostly exposed to the front side of the electronic device 101 when the electronic device 101 is in the slid-out state (e.g., FIG. 3 or FIG. 5B). The second display area A2 may be at least partially accommodated inside the electronic device 101 when the electronic device 101 is in the slid-in state (e.g., FIG. 2 or FIG. 5A).

According to an embodiment, the third area A3 may extend from the first display area A2. The third area A3 may be mostly accommodated inside the electronic device 101 when the electronic device 101 is in the slid-in state (e.g., FIG. 2 or FIG. 5A). The third area A3 may be at least partially visually exposed to the front side of the electronic device 101 when the electronic device 101 is in the slid-out state (e.g., FIG. 3 or FIG. 5B).

According to an embodiment, the support structure 303 may include a flexible lattice plate 305, an adhesive member 350, a multi-bar structure 360 (e.g., the multi-bar structure 232 of FIGS. 4 to 5B), a head 370, or a buffer member 380.

According to an embodiment, the flexible lattice plate 305 may include a first lattice plate 310, a second lattice plate 320, a third lattice plate 330, and/or a fourth lattice plate 340.

According to an embodiment, the plurality of lattice plates 310, 320, 330, and 340 may be defined and/or referred to as a plurality of support layers 310, 320, 330, and 340. The plurality of lattice plates 310, 320, 330, and 340 may be defined and/or referred to as a plurality of lattice layers 310, 320, 330, and 340.

According to an embodiment, the first lattice plate 310 may generally have a panel shape. The first lattice plate 310 may be coupled to the rear surface of the display 301. The first lattice plate 310 may be stacked on the rear surface of the second display area A2 and the rear surface of the third area A3.

According to an embodiment, the first lattice plate 310 may include a bendable material. For example, the first lattice plate 310 may include a material (e.g., metal) that is variable into a shape corresponding to a shape of the second display area A2 and a shape of the third area A3, which are bent or unfolded.

According to an embodiment, the first lattice plate 310 may include a first pattern 313 configured to facilitate a change in shape of the first lattice plate 310. The first pattern 313 may include holes, grooves, or slits formed in the first lattice plate 310 and configured to allow the first lattice plate 310 to be easily folded. For example, the first pattern 313 may include elongated holes and/or elongated grooves.

According to an embodiment, the first lattice plate 310 may include a first portion 311 or a second portion 312. According to an embodiment, the first portion 311 may be disposed or configured to support the second display area A2. According to an embodiment, at least a portion of the first portion 311 may support a portion of the rear surface of the first display area A1. The second portion 312 may be disposed or configured to support the third area A3. The second portion 312 may extend from the first portion 311. The second portion 312 may be integrally formed with the first portion 311, or may be formed as a member separate from the first portion 311 and assembled with the first portion 311.

According to an embodiment, the second lattice plate 320 may be configured to support the second display area A2 and the first portion 311 of the first lattice plate 310.

According to an embodiment, the second lattice plate 320 may generally have a panel shape. The second lattice plate 320 may be coupled to the rear surface of the first portion 311 of the first lattice plate 310. The second lattice plate 320 may be stacked on the rear surface of the first portion 311 of the first lattice plate 310.

According to an embodiment, the second lattice plate 320 may include a bendable material. For example, the second lattice plate 320 may include a material (e.g., metal) that is variable into a shape corresponding to a shape of the second display area A2, which is bent or unfolded.

According to an embodiment, the second lattice plate 320 may include a second pattern 323 configured to facilitate a change in shape of the second lattice plate 320. The second pattern 323 may include holes, grooves, or slits formed in the second lattice plate 320 and configured to allow the second lattice plate 320 to be easily folded. For example, the second pattern 323 may include elongated holes and/or elongated grooves.

According to an embodiment, the third lattice plate 330 may be configured to support the second display area A2 and the second lattice plate 320.

According to an embodiment, the third lattice plate 330 may generally have a panel shape. The third lattice plate 330 may be coupled to the rear surface of the second lattice plate 320. The third lattice plate 330 may be stacked on the rear surface of the second lattice plate 320.

According to an embodiment, the third lattice plate 330 may include a bendable material. For example, the third lattice plate 330 may include a material (e.g., metal) that is variable into a shape corresponding to a shape of the second display area A2, which is bent or unfolded.

According to an embodiment, the third lattice plate 330 may include a third pattern 333 configured to facilitate a change in shape of the third lattice plate 330. The third pattern 333 may include holes, grooves, or slits formed in the third lattice plate 330 and configured to allow the third lattice plate 330 to be easily folded. For example, the third pattern 333 may include elongated holes and/or elongated grooves.

According to an embodiment, the fourth lattice plate 340 may be configured to support the second display area A2 and the third lattice plate 330.

According to an embodiment, the fourth lattice plate 340 may generally have a panel shape. The fourth lattice plate 340 may be coupled to the rear surface of the third lattice plate 330. The first lattice plate 310 may be stacked on the rear surface of the third lattice plate 330.

According to an embodiment, the fourth lattice plate 340 may include a bendable material. For example, the fourth lattice plate 340 may include a material (e.g., metal) that is variable into a shape corresponding to a shape of the second display area A2, which is bent or unfolded.

According to an embodiment, the fourth lattice plate 340 may include a fourth pattern 343 configured to facilitate a change in shape of the fourth lattice plate 340. The fourth pattern 343 may include holes, grooves, or slits formed in the fourth lattice plate 340 and configured to allow the fourth lattice plate 340 to be easily folded. For example, the fourth pattern 343 may include elongated holes and/or elongated grooves.

According to an embodiment, the patterns 313, 323, 333, and 343 of the lattice plates 310, 320, 330, and 340 may be defined and/or referred to as lattice patterns.

According to an embodiment, the multi-bar structure 360 may include a plurality of bars. The plurality of bars may be spaced apart from each other at predetermined intervals. The multi-bar structure 360 may be configured to support the third area A3. The multi-bar structure 360 may be configured to support the second portion 312 of the first lattice plate 310. The multi-bar structure 360 may be coupled to the rear surface of the second portion 312 of the first lattice plate 310. The multi-bar structure 360 may be stacked on the rear surface of the second portion 312 of the first lattice plate 310.

According to an embodiment, the head 370 may include first heads 371 and/or second heads 372. The first heads 371 may be coupled to the first portion 311 of the first lattice plate 310 and the fourth lattice plate 340. The first heads 371 may be inserted into a slit (e.g., the slit 251 of FIG. 4) of a guide rail (e.g., the guide rail 250 of FIG. 4). When the electronic device 101 transitions from the slid-in state to the slid-out state, or when the electronic device 101 transitions from the slid-out state to the slid-in state, the first heads 371 associated with the second display area A2 may move along the slit of the guide rail. The second heads 372 may be coupled to the second portion 312 of the first lattice plate 310 and the multi-bar structure 360. When the electronic device 101 transitions from the slid-in state to the slid-out state, or when the electronic device 101 transitions from the slid-out state to the slid-in state, the second heads 372 associated with the third area A3 may move along the slit of the guide rail.

According to an embodiment, the adhesive member 350 may be disposed between the second portion 312 of the first lattice plate 310 and the multi-bar structure 360. The multi-bar structure 360 may be bonded to the second portion 312 of the first lattice plate 310 through the adhesive member 350. The adhesive member 350 may include a heat-sealing tape, but is not limited thereto, and may include various adhesive materials. According to an embodiment, the adhesive member 350 may be omitted.

According to an embodiment, the buffer member 380 may be disposed on the lattice plates 310, 320, 330, and 340. For example, the buffer member 380 may be configured to support the second display area A2 visually exposed to the outside of the electronic device 101 when the electronic device 101 transitions from the slid-in state to the slid-out state. The buffer member 380 may include a sponge or a tape. According to an embodiment, the buffer member 380 may be omitted.

According to an embodiment, the buffer member 380 may include a first buffer member 381, a second buffer member 382, or a third buffer member 383. The first buffer member 381 may be disposed between the first portion 311 of the first lattice plate 310 and the second lattice plate 320. The second buffer member 382 may be disposed between the second lattice plate 320 and the third lattice plate 330. The third buffer member 383 may be disposed between the third lattice plate 330 and the fourth lattice plate 340.

According to an embodiment, the multi-bar structure 360 may be disposed to support at least a portion of the flexible lattice plate 305 corresponding to the third area A3 of the display 301 (e.g., the second portion 312 of the first lattice plate 310). The third area A3 may be supported by the multi-bar structure 360, thereby improving rigidity.

According to an embodiment, another portion of the flexible lattice plate 305 supporting the second display area A2 of the display 301 may include multiple lattice layers. The multiple lattice layers may include the first portion 311 of the first lattice plate 310, the second lattice plate 320, the third lattice plate 330, and the fourth lattice plate 340.

FIGS. 6B and 7A are cross-sectional views of the electronic device 101 in the slid-in state (e.g., FIG. 2 or FIG. 5A).

Referring to FIGS. 6B and 7A, the first display area A1 of the display 301 may be supported by a first surface F1 (e.g., the first surface F1 of FIG. 4) of a second cover member 221 (e.g., the second cover member 221 of FIGS. 4 to 5B). The first display area A1 may form a substantially flat surface when the electronic device 101 is in the slid-in state. The first display area A1 may be exposed to the front side of the electronic device 101. For example, the first display area A1 may be exposed to the outside of the electronic device 101.

According to an embodiment, the first display area A1 may be visually exposed to the front side of a housing (e.g., the housing 210 of FIG. 2 or the housing 210 of FIG. 4) (e.g., the +Z direction of FIGS. 2, 4, 6B, 6C, 7A, and 7B) when a second housing portion (e.g., the second housing portion 202 of FIGS. 2 to 5B) is located in a first position (e.g., FIG. 2A, FIG. 5A, FIG. 6B, or FIG. 7A) with respect to a first housing portion (e.g., the first housing portion 201 of FIGS. 2 to 5B).

According to an embodiment, the second display area A2 may be supported by flexible lattice plates 3051 and 3052 (e.g., the flexible lattice plate 305 of FIG. 6A). For example, the second display area A2 may be supported by a portion of the flexible lattice plates 3051 and 3052 corresponding to the second display area A2. The portion of the flexible lattice plates 3051 and 3052 corresponding to the second display area A2 may include the first portion 311 of the first lattice plate 310, a second lattice plate (e.g., the second lattice plate 320 of FIG. 5), a third lattice plate (e.g., the third lattice plate 330 of FIG. 5), and a fourth lattice plate (e.g., the fourth lattice plate 340 of FIG. 5).

According to an embodiment, the second display area A2 may be accommodated inside the electronic device 101 when the electronic device 101 is in the slid-in state. For example, the second display area A2 supported by the portion of the flexible lattice plates 3051 and 3052 may not be visually exposed to the front side of the housing (e.g., the housing 210 of FIG. 2 or the housing 210 of FIG. 4) when the second housing portion (e.g., the second housing portion 202 of FIGS. 2 to 5B) is located in the first position (e.g., FIG. 2A, FIG. 5A, FIG. 6B, or FIG. 7A) with respect to the first housing portion (e.g., the first housing portion 201 of FIGS. 2 to 5B). At least a portion of the second display area A2 may be deformed into a curved shape at a position corresponding to a curved surface (e.g., the curved surface 213a of FIG. 4) of a frame (e.g., the frame 213 of FIG. 4). At least a portion of the flexible lattice plates 3051 and 3052 corresponding to the second display area A2 may be deformed into a curved shape at a position corresponding to the curved surface of the frame.

According to an embodiment, at least a portion of the second display area A2 may be covered by a (1-1)^{th} side wall 211a (e.g., the (1-1)^{th} side wall 211a of FIGS. 2 and 3) of a first cover member 211 (e.g., the first cover member 211 of FIG. 4) when the electronic device 101 is in the slid-in state. For example, an inner side surface of the (1-1)^{th} side wall 211a may face a curved surface formed by the second display area A2 and may have a shape corresponding to the shape of the curved surface.

According to an embodiment, the third area A3 may be supported by the flexible lattice plates 3051 and 3052 and a multi-bar structure 360 or 3601. For example, the third area A3 may be supported by at least a portion of the flexible lattice plates 3051 and 3052 corresponding to the third area A3 (e.g., the second portion 312 of the first lattice plate 310) and the multi-bar structure 360 or 3601.

According to an embodiment, the third area A3 may be completely accommodated inside the electronic device 101 when the electronic device 101 is in the slid-in state. The third area A3 may be supported by a portion of the flexible lattice plates 3051 and 3052 (e.g., the second portion 312 of the first plate 310) and the multi-bar structure 360 or 3601. The third area A3 may form a substantially flat surface inside the electronic device 101.

For example, the third area A3 may not be visually exposed to the front side of the housing (e.g., the housing 210 of FIG. 2 or the housing 210 of FIG. 4) when the second housing portion (e.g., the second housing portion 202 of FIGS. 2 to 5B) is located in the first position (e.g., FIG. 2A, FIG. 5A, FIG. 6B, or FIG. 7A) with respect to the first housing portion (e.g., the first housing portion 201 of FIGS. 2 to 5B). FIGS. 6C and 7B are cross-sectional views of the electronic device 101 in the slid-out state (e.g., FIG. 3 or FIG. 5B).

Referring to FIGS. 6C and 7B, the first display area A1 may be visually exposed to the front side of the housing (e.g., the housing 210 of FIG. 2 or the housing 210 of FIG. 4) (e.g., the +Z direction of FIGS. 2, 4, 6B, 6C, 7A, and 7B) when the second housing portion (e.g., the second housing portion 202 of FIGS. 2 to 5B) is located in a second position (e.g., FIG. 2B, FIG. 5B, FIG. 6C, or FIG. 7B) with respect to the first housing portion (e.g., the first housing portion 201 of FIGS. 2 to 5B).

According to an embodiment, the second display area A2 may form a substantially flat surface when the electronic device 101 is in the slid-out state. The second display area A2 may form a flat surface together with the first display area (e.g., the first display area A1 of FIG. 6A). The second display area A2 may be completely exposed to the front side of the electronic device 101. The second display area A2 may be completely exposed to the outside of the electronic device 101. For example, the second display area A2 supported by a portion of the flexible lattice plates 3051 and 3052 may be visually exposed to the front side of the housing (e.g., the housing 210 of FIG. 2 or the housing 210 of FIG. 4) (e.g., the +Z direction of FIGS. 2, 4, 6B, 6C, 7A, and 7B) when the second housing portion (e.g., the second housing portion 202 of FIGS. 2 to 5B) is located in the second position (e.g., FIG. 2B, FIG. 5B, FIG. 6C, or FIG. 7B) with respect to the first housing portion (e.g., the first housing portion 201 of FIGS. 2 to 5B).

According to an embodiment, the second display area A2 may be supported by flexible lattice plates 3051 and 3052 (e.g., the flexible lattice plate 305 of FIG. 6A). For example, at least a portion of the flexible lattice plates 3051 and 3052 corresponding to the second display area A2 may form a substantially flat surface and may support the second display area A2 such that the second display area A2 is flattened.

According to an embodiment, at least a portion of the third area A3 may be deformed into a curved shape at a position corresponding to a curved surface (e.g., the curved surface 213a of FIG. 4) of a frame (e.g., the frame 213 of FIG. 4). The second portion 312 of the first lattice plate 310 may be deformed into a curved shape at a position corresponding to the curved surface of the frame, and the multi-bar structure 360 or 3601 may be arranged in a curved surface at a position corresponding to the curved surface of the frame.

According to an embodiment, at least a portion of the third area A3 may be covered by the (1-1)^{th} side wall 211a of the first cover member 211 when the electronic device 101 is in the slid-out state. For example, an inner side surface of the (1-1)^{th} side wall 211a may face a curved surface formed by the third area A3 and may have a shape corresponding to the shape of the curved surface.

Referring to FIG. 6C, the third area A3 may be at least partially exposed to the front side of the electronic device 101 when the electronic device 101 is in the slid-out state. At least a portion of the third area A3 visually exposed to the outside of the electronic device 101 may form a substantially flat surface with the second display area A2. A remaining portion of the third area A3 may be accommodated inside the electronic device 101.

According to an embodiment, when the electronic device 101 is in the slid-out state (e.g., FIG. 3, FIG. 5B, or FIG. 6C), the second portion 312 of the first lattice plate 310 and the multi-bar structure 360 may support the third area A3 such that the third area A3 visually exposed to the front side or the outside of the electronic device 101 maintains a flat state. For example, as a portion of the second portion 312 of the first lattice plate 310 forms a substantially flat surface, the third area A3 visually exposed to the front side or the outside of the electronic device 101 may maintain a flat state.

Referring to FIG. 7B, the third area A3 may not be visually exposed to the front side of the electronic device 101 when the electronic device 101 is in the slid-out state.

According to an embodiment, when the electronic device 101 is in the slid-out state (e.g., FIG. 3, FIG. 5B, or FIG. 7B), the second portion 312 of the first lattice plate 310 and the multi-bar structure 3601 may support the third area A3 accommodated inside the electronic device 101. For example, the third area A3 may not be visually exposed to the front side of the housing (e.g., the housing 210 of FIG. 2 or the housing 210 of FIG. 4) (e.g., the +Z direction of FIGS. 2, 4, 6B, 6C, 7A, and 7B) when the second housing portion (e.g., the second housing portion 202 of FIGS. 2 to 5B) is located in the second position (e.g., FIG. 2B, FIG. 5B, or FIG. 7B) with respect to the first housing portion (e.g., the first housing portion 201 of FIGS. 2 to 5B).

Referring to FIGS. 7A and 7B, when the electronic device 101 is in the slid-out state or the slid-in state, the third area A3 may not be visually exposed to the front side of the electronic device 101 or the housing. The third area A3 may have no pixel elements. The first display area A1 and the second display area A2, which may be visually exposed to the front side of the electronic device 101 or the housing, may have pixel elements for visually providing a display screen (or a display image) to a user. According to an embodiment, the third area A3 may include pixel elements, and in this case, when the pixel elements of the first display area A1 and the second display area A2 operate, the pixel elements of the third area A3 may be controlled not to operate.

FIG. 8A is a rear view illustrating a support structure according to an embodiment of the disclosure.

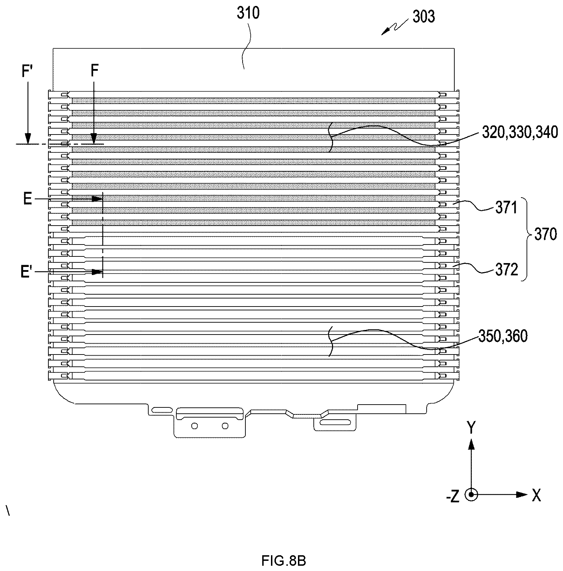

FIG. 8B is a rear view illustrating a support structure according to an embodiment of the disclosure.

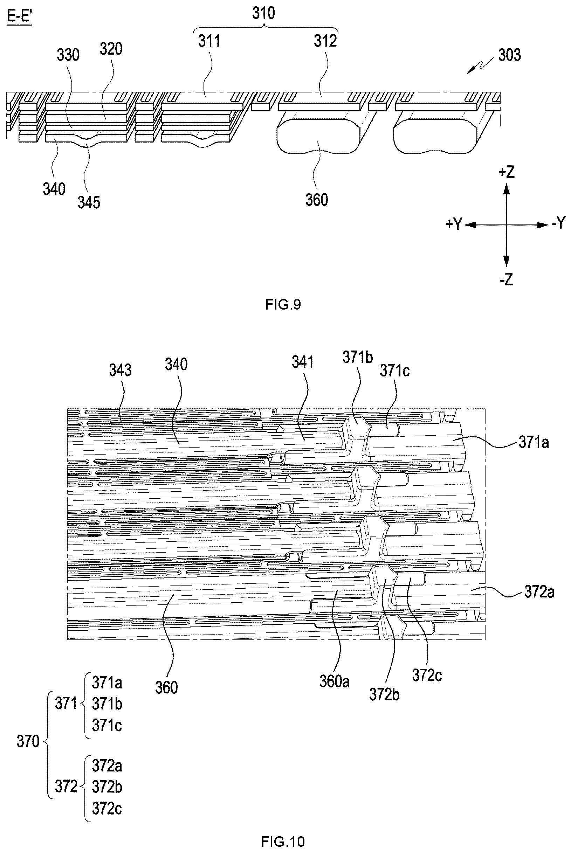

FIG. 9 is a cross-sectional view taken along line E-E' of FIG. 8B, according to an embodiment of the disclosure.

FIG. 10 is a perspective view of a support structure according to an embodiment of the disclosure.

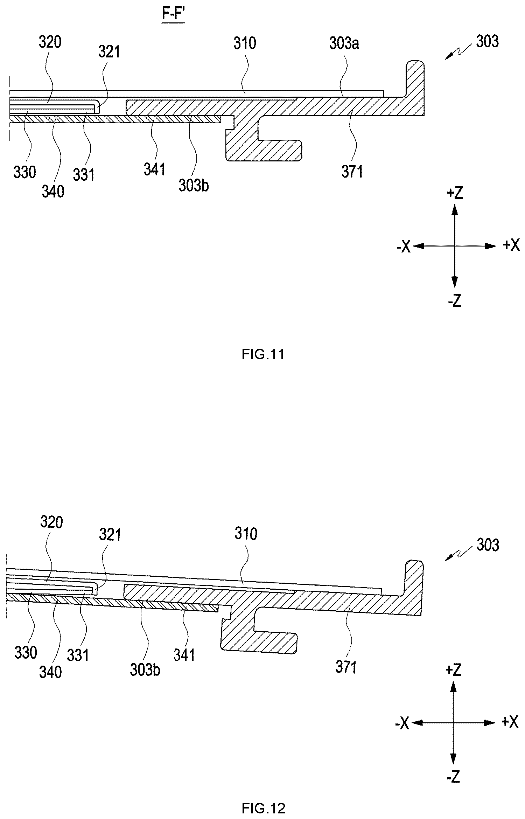

FIG. 11 is a cross-sectional view taken along line E-E' of FIG. 8B, according to an embodiment of the disclosure.

FIG. 12 is a cross-sectional view of a support structure according to an embodiment of the disclosure.

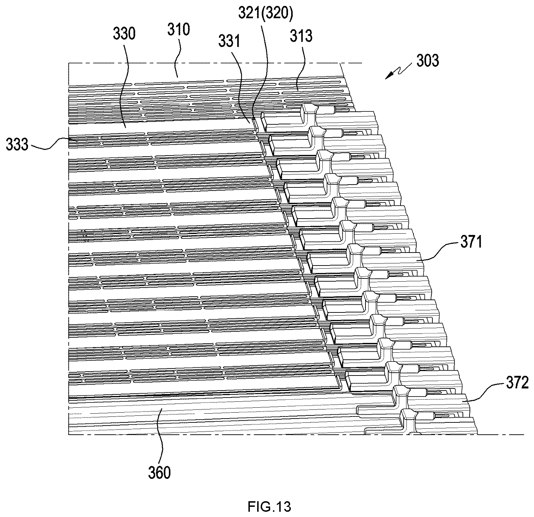

FIG. 13 is a perspective view of a support structure according to an embodiment of the disclosure.

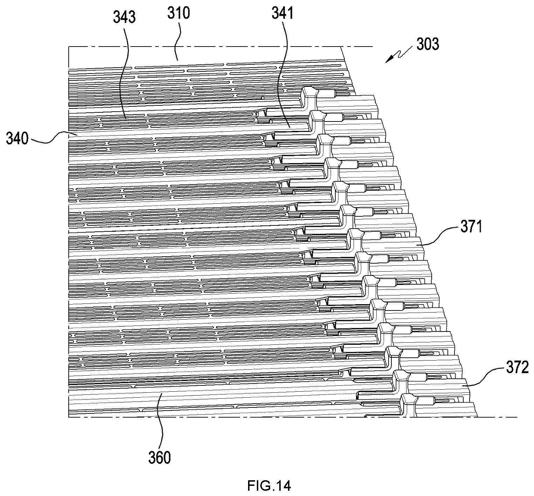

FIG. 14 is a perspective view of a support structure according to an embodiment of the disclosure.

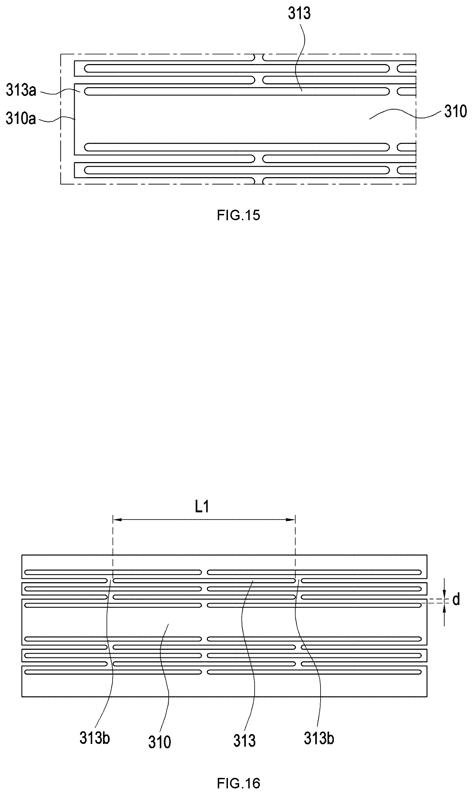

The embodiments of FIGS. 8A to 14 may be combined with the embodiments of FIGS. 1 to 7B or the embodiments of FIGS. 15 to 24.

Referring to FIGS. 8A to 14, the support structure 303 (e.g., the support structure 303 of FIGS. 6A to 6C) may include a first lattice plate 310, a second lattice plate 320, a third lattice plate 330, a fourth lattice plate 340, an adhesive member 350, a multi-bar structure 360, or a head 370.

The configuration of the first lattice plate 310, the second lattice plate 320, the third lattice plate 330, the fourth lattice plate 340, the adhesive member 350, the multi-bar structure 360, or the head 370 of FIGS. 8A to 14 may be partially or entirely the same as the configuration of the first lattice plate 310, the second lattice plate 320, the third lattice plate 330, the fourth lattice plate 340, the adhesive member 350, the multi-bar structure 360, or the head 370 of FIGS. 6A to 6C.

Referring to FIGS. 8A and 8B, the support structure 303 may include a plurality of areas 303a, 303b, 303c, and 303d.

According to an embodiment, the plurality of areas 303a, 303b, 303c, and 303d may be adhesive areas for bonding components of the support structure 303 to each other.

According to an embodiment, a first adhesive area 303a may be configured to bond the first lattice plate 310 and a first head 371 (e.g., the first head 371 of FIG. 6A) to each other, or to bond the multi-bar structure 360 (e.g., the multi-bar structure 360 of FIG. 6A) and a second head 372 (e.g., the second head 372 of FIG. 6A) to each other.

According to an embodiment, the first adhesive area 303a may be a welding area in which the first lattice plate 310 and the first head 371 are welded. The first adhesive area 303a may be a welding area in which the multi-bar structure 360 and the second head 372 are welded.

According to an embodiment, the second adhesive area 303b may be configured to bond the fourth lattice plate 340 and the first head 371 to each other. The second adhesive area 303b may be a welding area in which the fourth lattice plate 340 and the first head 371 are welded.

According to an embodiment, the second adhesive area 303b may be located inside the first adhesive area 303a.

According to an embodiment, the third adhesive area 303c may include a first buffer member (e.g., the first buffer member 381 of FIG. 6A) bonding the first portion of the first lattice plate 310 (e.g., the first portion 311 of FIG. 6A) and the second lattice plate 320 to each other, a second buffer member (e.g., the second buffer member 382 of FIG. 6A) bonding the second lattice plate 320 and the third lattice plate 330 to each other, and a third buffer member (e.g., the third buffer member 383 of FIG. 6A) bonding the third lattice plate 330 and the fourth lattice plate 340 to each other.

According to an embodiment, the third adhesive area 303c may be located inside the second adhesive area 303b.

According to an embodiment, the fourth adhesive area 303d may include an adhesive member 350 bonding the second portion of the first lattice plate 310 (e.g., the second portion 312 of FIG. 6A) and the multi-bar structure 360 to each other.

According to an embodiment, the fourth adhesive area 303d may be located inside the first adhesive area 303a.

Referring to FIG. 9, the second lattice plate 320, the third lattice plate 330, and the fourth lattice plate 340 may be sequentially stacked below the first portion 311 of the first lattice plate 310 (e.g., in the -Z direction).

According to an embodiment, the multi-bar structure 360 may be disposed below the second portion 312 of the first lattice plate 310.

According to an embodiment, the fourth lattice plate 340 may include a protruding portion 345 protruding downward (e.g., in the -Z direction) from at least a portion of the fourth lattice plate 340.

According to an embodiment, the protruding portion 345 may extend in a width direction of the fourth lattice plate 340 (e.g., the X-axis direction of FIG. 6A). According to an embodiment, the protruding portion 345 may be defined and/or referred to as a bead. The protruding portion 345 may be configured to limit and/or reduce bending of a display assembly (e.g., the display assembly 300 of FIG. 6A) in an outward direction of the electronic device due to a repulsive force when the state of the electronic device (e.g., the electronic device 101 of FIGS. 4 to 5B or FIGS. 6B to 6C) transitions.

Referring to FIG. 10, the first head 371 may be coupled to the fourth lattice plate 340. The second head 372 may be coupled to the multi-bar structure 360.

According to an embodiment, the first head 371 may include a first body portion 371a, a first extension portion 371b extending from the first body portion 371a, and a first pole portion 371c protruding from a portion of the first extension portion 371b.

According to an embodiment, the first body portion 371a may be stacked on the first portion 311 of the first lattice plate 310. A first coupling portion 341 of the fourth lattice plate 340 may be coupled to the first body portion 371a. The first coupling portion 341 may protrude from an edge of the fourth lattice plate 340 or may be defined as the edge of the fourth lattice plate 340, but is not limited thereto. The first coupling portion 341 may be welded to the first body portion 371a.

According to an embodiment, the first extension portion 371b may extend in a direction perpendicular to the first body portion 371a, but is not limited thereto.

According to an embodiment, the first pole portion 371c may protrude from a side surface of the first extension portion 371b, but is not limited thereto. The first pole portion 371c may be inserted into a slit (e.g., the slit 251 of FIG. 4) of a guide rail (e.g., the guide rail 250 of FIG. 4).

According to an embodiment, the second head 372 may include a second body portion 372a, a second extension portion 372b extending from the second body portion 372a, and a second pole portion 372c protruding from a portion of the second extension portion 372b.

According to an embodiment, the second body portion 372a may be stacked on the second portion 312 of the first lattice plate 310. A second coupling portion 360a of the multi-bar structure 360 may be coupled to the second body portion 372a. The second coupling portion 360a may be defined as an edge of each bar of the multi-bar structure 360, but is not limited thereto. The second coupling portion 360a may be welded to the second body portion 372a.

According to an embodiment, the second extension portion 372b may extend in a direction perpendicular to the second body portion 372a, but is not limited thereto.

According to an embodiment, the second pole portion 372c may protrude from a side surface of the second extension portion 372b, but is not limited thereto. The second pole portion 372c may be inserted into a slit (e.g., the slit 251 of FIG. 4) of a guide rail (e.g., the guide rail 250 of FIG. 4).

Referring to FIGS. 11 to 12, the second lattice plate 320 may be at least partially disposed between the first lattice plate 310 and the third lattice plate 330.

According to an embodiment, the second lattice plate 320 may be disposed to surround the third lattice plate 330. The second lattice plate 320 may cover an edge of the third lattice plate 330. The second lattice plate 320 may include a cover portion 321 extending from an edge of the second lattice plate 320 and surrounding the edge 331 of the third lattice plate 330. When the state of the electronic device transitions, a repulsive force may act on a display assembly (e.g., the display assembly 300 of FIGS. 6A to 6C). Due to the repulsive force, a central portion of the display assembly (e.g., a central portion in the X-axis direction of FIG. 6A, FIG. 11, or FIG. 12) may be deformed to be relatively convex with respect to other portions. When a central portion of the first lattice plate 310 and a central portion of the second lattice plate 320 are deformed to be convex, the second lattice plate 320 may be reduced in length in the width direction (e.g., the X-axis direction of FIGS. 11 and 12), as illustrated in FIG. 12. In this case, the cover portion 321 of the second lattice plate 320 may be engaged with the edge 331 of the third lattice plate 330. Accordingly, the reduction in length of the second lattice plate 320 in the width direction may be limited and/or reduced, and convex deformation of the central portion of the second lattice plate 320 may be limited and/or reduced. Accordingly, convex deformation of the central portion of the display assembly may be limited, reduced, and/or mitigated.

FIG. 13 is a perspective view of the support structure 303 in a state in which the fourth lattice plate 340 is removed. FIG. 14 is a perspective view of the support structure 303 in a state in which the fourth lattice plate 340 is coupled.

Referring to FIGS. 11 to 14, the first lattice plate 310 may be welded to the front surface of the first body portion of the first head 371 (e.g., the first body portion 371a of FIG. 10) (e.g., a surface oriented in the +Z direction of FIG. 11), thereby forming the first adhesive area 303a. The fourth lattice plate 340 may be welded to the rear surface of the first body portion of the first head 371 (e.g., a surface oriented in the -Z direction of FIG. 11), thereby forming the fourth adhesive area 303d.

According to an embodiment, an edge of each bar of the multi-bar structure 360 may be welded to the rear surface of the second body portion of the second head 372 (e.g., the second body portion 372a of FIG. 10).

FIG. 15 is a plan view of a support structure according to an embodiment of the disclosure.

FIG. 16 is a plan view illustrating a portion of the support structure according to an embodiment of the disclosure.

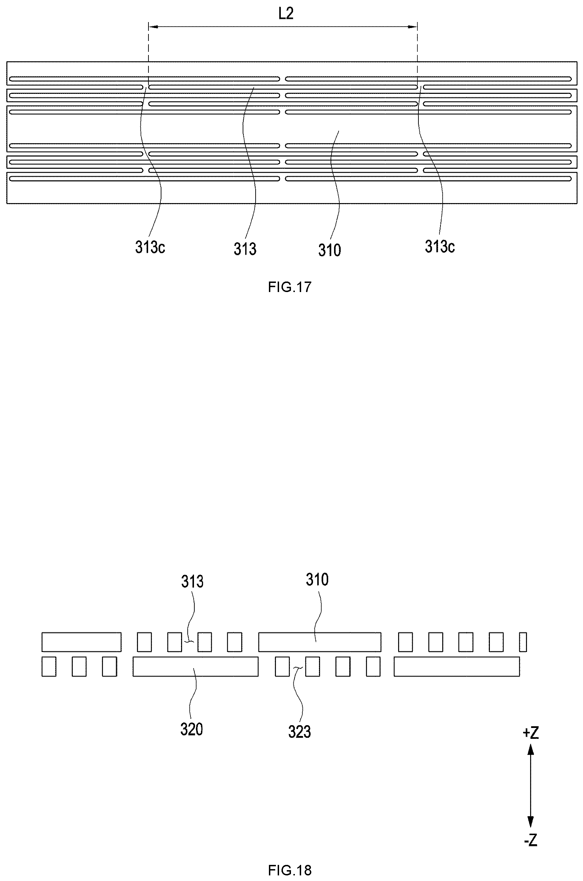

FIG. 17 is a plan view illustrating a portion of the support structure according to an embodiment of the disclosure.

The embodiments of FIGS. 15 to 17 may be combined with the embodiments of FIGS. 1 to 14 or the embodiments of FIGS. 18 to 24.

Referring to FIGS. 15 to 17, the first lattice plate 310 (e.g., the first lattice plate 310 of FIGS. 6A to 14) may include a first pattern 313 (e.g., the first pattern 313 of FIG. 6A).

The description of the first lattice plate 310 and the first pattern 313 described with reference to FIGS. 15 to 17 as an example may be equally or similarly applied and/or understood with respect to the second lattice plate 320, the second pattern 323, the third lattice plate 330, the third pattern 333, the fourth lattice plate 340, and the fourth pattern 343 described with reference to FIG. 6A as an example.

According to an embodiment, the first pattern 313 may include a plurality of holes. The plurality of holes of the first pattern 313 may be spaced apart from each other.

Referring to FIG. 15, at least one hole of the first pattern 313 of the first lattice plate 310 may form at least a portion of an edge 310a of the first lattice plate 310. The at least one hole of the first pattern 313 of the first lattice plate 310 may be spaced apart from the edge 310a of the first lattice plate 310. Between the edge 310a of the first lattice plate 310 and the at least one hole, a portion 313a of the first lattice plate 310 may form a side surface of the at least one hole. As the at least one hole of the first pattern 313 is surrounded by the portion 313a of the first lattice plate 310, rigidity of the edge 310a of the first lattice plate 310 may be improved.

Referring to FIGS. 16 and 17, one hole of the first pattern 313 of the first lattice plate 310 may have a predetermined length L1 or L2 (e.g., a length in the X-axis direction of FIG. 6A). The predetermined length L1 or L2 may be defined by portions 313b of the first lattice plate 310. For example, both ends of one hole may be defined by the portions 313b of the first lattice plate 310. The predetermined length L1 or L2 may be variously designed according to a thickness of the first lattice plate 310, a material of the first lattice plate 310, or a degree of deformation of the display assembly.

Referring to FIG. 16 as an example, the predetermined length L1 of one hole of the first pattern 313 may be about 5.0 mm to about 6.0 mm, but is not limited thereto. The predetermined length L1 may be about 5.5 mm, but is not limited thereto.

Referring to FIG. 17 as an example, the predetermined length L2 of one hole of the first pattern 313 may be about 7.8 mm to about 9.3 mm, but is not limited thereto. The predetermined length L2 may be about 8.5 mm, but is not limited thereto.

Referring to FIG. 16, one hole of the first pattern 313 may be spaced apart from another hole adjacent to the one hole by a predetermined distance d (e.g., a distance in the Y-axis direction of FIG. 6A). The predetermined distance d may be variously designed according to a thickness of the first lattice plate 310, a material of the first lattice plate 310, or a degree of deformation of the display assembly. The predetermined distance d may be about 0.12 mm to about 0.15 mm, but is not limited thereto. The predetermined distance d may be about 0.12 mm to about 0.15 mm, but is not limited thereto.

FIG. 18 is a view illustrating a stacked relationship of a support structure according to an embodiment of the disclosure.

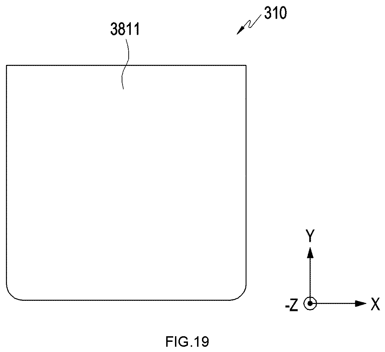

The embodiment of FIG. 18 may be combined with the embodiments of FIGS. 1 to 17 or the embodiments of FIGS. 19 to 24.

Referring to FIG. 18, the second lattice plate 320 (e.g., the second lattice plate 320 of FIGS. 6A to 14) may be stacked below the first lattice plate 310 (e.g., the first lattice plate 310 of FIGS. 6A to 17) (e.g., in the -Z direction). The first lattice plate 310 may include a first pattern 313 (e.g., the first pattern 313 of FIG. 6A), and the second lattice plate 320 may include a second pattern 323 (e.g., the second pattern 323 of FIG. 6A).

The description of the first lattice plate 310 and the second lattice plate 320 described with reference to FIG. 18 as an example may be equally and/or similarly applied and/or interpreted with respect to the second lattice plate 320 and the third lattice plate 330, and may be equally and/or similarly applied and/or interpreted with respect to the third lattice plate 330 and the fourth lattice plate 340.

According to an embodiment, the first pattern 313 may include a plurality of holes. The second pattern 323 may include a plurality of holes.

According to an embodiment, the first pattern 313 may not overlap the second pattern 323 in the thickness direction of a support structure (e.g., the support structure 303 of FIG. 6A) (e.g., the Z-axis direction of FIG. 18). Accordingly, a second display area visually exposed to the outside of the electronic device (e.g., the second display area A2 of FIGS. 6A to 6C) may be supported to be flat. For example, as the first pattern 313 and the second pattern 323 do not overlap each other, at least partial sagging of the second display area may be limited and/or reduced , compared to a case in which the first pattern 313 and the second pattern 323 overlap each other.

FIG. 19 is a view illustrating a first buffer member of a support structure according to an embodiment of the disclosure.

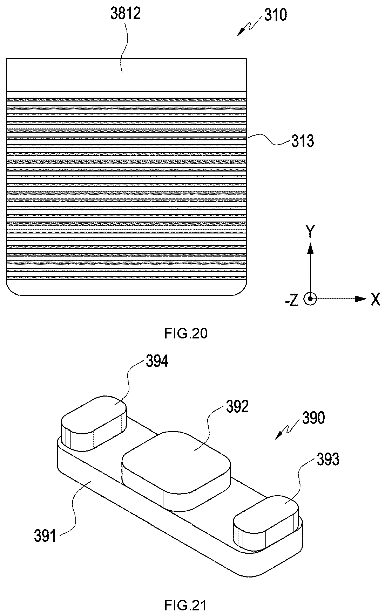

FIG. 20 is a view illustrating a first buffer member of a support structure according to an embodiment of the disclosure.

The embodiments of FIGS. 19 to 20 may be combined with the embodiments of FIGS. 1 to 18 or the embodiments of FIGS. 21 to 24.

Referring to FIGS. 19 to 20, the first buffer member 3811 or 3812 (e.g., the first buffer member 381 of FIG. 6A) may be stacked on the first lattice plate 310 (e.g., the first lattice plate 310 of FIG. 6A).

Referring to FIG. 19, the first buffer member 3811 may have a shape and/or size corresponding to the first lattice plate 310 so as to completely cover the first lattice plate 310. When the first buffer member 3811 completely covers the first lattice plate 310, a first pattern of the first lattice plate 310 (e.g., the first pattern 313 of FIG. 6A) may not be exposed.

Referring to FIG. 20, the first buffer member 3812 may have a shape that does not correspond to the first lattice plate 310 and/or a size smaller than the size of the first lattice plate 310 so as to partially cover the first lattice plate 310. The first buffer member 3812 may be stacked only on a portion of the first lattice plate 310 that does not overlap the first pattern 313.

The shape, size, and/or arrangement position of the buffer member 3811 or 3812 described with reference to FIGS. 19 and 20 as an example are illustrative, and the buffer member 3811 or 3812 is not limited thereto.

FIG. 21 is a perspective view illustrating a fixing member according to an embodiment of the disclosure.

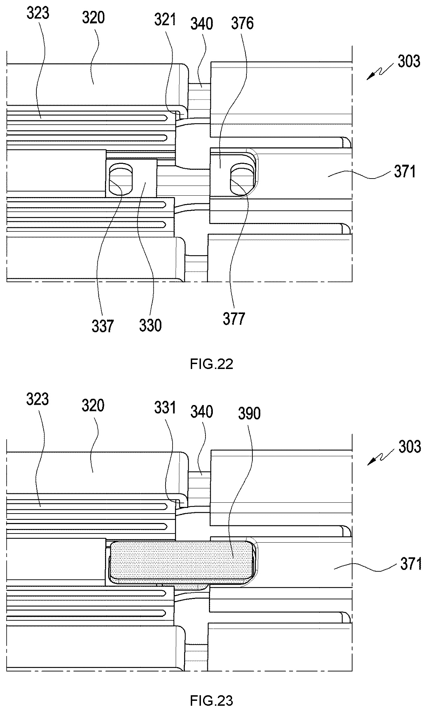

FIG. 22 is a perspective view of a support structure according to an embodiment of the disclosure.

FIG. 23 is a perspective view of a support structure to which a fixing member is coupled according to an embodiment of the disclosure.

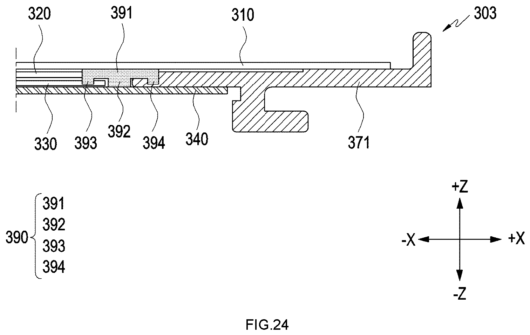

FIG. 24 is a perspective view of a support structure according to an embodiment of the disclosure.

The embodiments of FIGS. 21 to 24 may be combined with the embodiments of FIGS. 1 to 23.

Referring to FIGS. 21 to 24, the support structure 303 (e.g., the support structure 303 of FIGS. 6A to 14) may further include a block 390.

According to an embodiment, the block 390 may include a base portion 391, a first insertion portion 392, a second insertion portion 393, or a third insertion portion 394. The block 390 may include an elastically deformable material (e.g., rubber), but is not limited thereto.

According to an embodiment, the base portion 391 may be formed to extend in one direction. The base portion 391 may have a size and/or length such that the insertion portions 392, 393, and 394 are spaced apart from each other.

According to an embodiment, the first insertion portion 392 may protrude or extend from one surface of the base portion 391. The second insertion portion 393 may protrude or extend from the one surface of the base portion 391. The third insertion portion 394 may protrude or extend from the one surface of the base portion 391. The first insertion portion 392 may be disposed between the second insertion portion 393 and the third insertion portion 394.

According to an embodiment, the block 390 may couple the first head 371 and the second support plate 320 to each other.

According to an embodiment, the third lattice plate 330 (e.g., the third lattice plate 330 of FIG. 6A) disposed between the fourth lattice plate 340 (e.g., the fourth lattice plate 340 of FIG. 6A) and the second lattice plate 320 (e.g., the second lattice plate 320 of FIG. 6A) may include a first accommodating portion 337. The first accommodating portion 337 may be disposed adjacent to an edge of the third lattice plate 330. The first accommodating portion 337 may include a hole or a groove. The second insertion portion 393 of the block 390 may be inserted into the first accommodating portion 337.

According to an embodiment, the first head 371 (e.g., the first head 371 of FIG. 6A) may include a recessed seating portion 376. The seating portion 376 may be formed in a first body portion of the first head 371 (e.g., the first body portion 371a of FIG. 10).

According to an embodiment, the first head 371 may include a second accommodating portion 377. The second accommodating portion 377 may include a hole or a groove formed in the seating portion 376. The third insertion portion 394 may be inserted into the second accommodating portion 377.

According to an embodiment, when the block 390 is fastened to the third lattice plate 330 and the first head 371, the base portion 391 may be disposed between the second lattice plate 320 and the first head 371. When the block 390 is fastened to the third lattice plate 330 and the first head 371, the first insertion portion 392 may be disposed between an edge of the third lattice plate 330 and an edge of the first head 371. For example, the first insertion portion 392 may be disposed between the third lattice plate 330 and the first head 371. When the block 390 is fastened to the third lattice plate 330 and the first head 371, the second insertion portion 393 may be inserted into the first accommodating portion 337, and the third insertion portion 394 may be inserted into the second accommodating portion 377.

When the state of the electronic device transitions, a repulsive force may act on a display assembly (e.g., the display assembly 300 of FIGS. 6A to 6C). Due to the repulsive force, the display assembly may be deformed such that a central portion thereof (e.g., the central portion in the X-axis direction of FIG. 6 or FIG. 24) is relatively convex with respect to other portions. When a central portion of the first lattice plate 310 and a central portion of the third lattice plate 330 are deformed to be convex, the third lattice plate 330 may be reduced in length in the width direction (e.g., the X-axis direction of FIG. 24). In this case, as the block 390 is fixed to the first head 371 and the third lattice plate 330, the first accommodating portion 337 of the third lattice plate 330 may be engaged with the second insertion portion 393 of the block 390. Accordingly, the reduction in length of the third lattice plate 330 in the width direction may be limited and/or reduced, and convex deformation of the central portion of the third lattice plate 330 may be limited and/or reduced. Accordingly, convex deformation of the central portion of the display assembly may be limited, reduced, and/or mitigated.

In an electronic device including a rollable display, when the electronic device transitions from a slid-in state to a slid-out state or from the slid-out state to the slid-in state, at least a portion of the rollable display may be unfolded or rolled, and accordingly, a size of a display visually exposed to the outside of the electronic device may be expanded or reduced. An electronic device including a rollable display may include a multi-bar structure including a plurality of bars configured to support a portion of the rollable display that is rolled or unfolded. The plurality of bars may be arranged to form a curved surface when the rollable display is rolled. When the plurality of bars are arranged to form a curved surface, a distance between one bar and an adjacent bar may be reduced. When the plurality of bars are arranged to form a flat surface, a distance between one bar and an adjacent bar may be increased. As the distances between the plurality of bars are varied with respect to each other as described above, the plurality of bars may require a predetermined minimum distance based on a state in which the plurality of bars form a flat surface. Due to such distances, the display visually exposed to the outside of the electronic device may have degraded display quality because the distances correspond to empty spaces and thus the surface of the display may become uneven.

According to an embodiment of the disclosure, an electronic device may be provided in which a display visually exposed to the outside of the electronic device is supported by multiple plates, thereby improving display quality.

However, problems to be solved in the disclosure are not limited to the above-mentioned problems and may be variously determined without departing from the spirit and scope of the disclosure.

According to an embodiment of the disclosure, a flexible display in which a phenomenon in which a central portion of the display becomes convex is suppressed or mitigated, and an electronic device including the same, may be provided.

The effects that may be obtained in the disclosure are not limited to the above-mentioned effects, and other effects not mentioned above will be clearly understood by those ordinarily skilled in the art to which the disclosure pertains from the following description.

According to an embodiment of the disclosure, an electronic device 101 may include a housing 210 including a first housing portion 201 and a second housing portion 202 configured to move with respect to the first housing portion 201.

According to an embodiment, the electronic device 101 may include a display 301 including a first display area A1, a second display area A2, and a third area A3.

According to an embodiment, the electronic device 101 may include a flexible lattice plate 305 disposed to support the second display area A2 and the third area A3 of the display 301.

According to an embodiment, the electronic device 101 may include a multi-bar structure 360 disposed to support at least a portion of the flexible lattice plate 305 corresponding to the third area A3 of the display 301.

According to an embodiment, another portion of the flexible lattice plate 305 supporting the second display area A2 of the display 301 may include multiple lattice layers.

According to an embodiment, each of the multiple lattice layers may include a lattice pattern 313, 323, 333, or 343 including elongated holes and/or elongated grooves.

According to an embodiment, the second display area A2 may extend from the first display area A1 and may be connected to the first display area A1.

According to an embodiment, the third area A3 may extend from the second display area A2 and may be connected to the second display area A2.

According to an embodiment, the third area A3 of the display 301 may have no pixel elements.

According to an embodiment, when the second housing portion 202 is located in a first position with respect to the first housing portion 201, the second display area A2 of the display 301 corresponding to the multiple lattice layers may not be visually exposed to a front side of the housing 210.

According to an embodiment, when the second housing portion 202 is located in a second position different from the first position with respect to the first housing portion 201, the second display area A2 of the display 301 corresponding to the multiple lattice layers may be visually exposed to the front side of the housing 210.

According to an embodiment, when the second housing portion 202 is located in the first position or the second position with respect to the first housing portion 201, the third area A3 corresponding to the multi-bar structure 360 may not be visually exposed to a front side of the housing 210.

According to an embodiment, when the second housing portion 202 is located in the first position or the second position with respect to the first housing portion 201, the first display area A1 may be visually exposed to a front side of the housing 210.

According to an embodiment, the flexible lattice plate 305 may include a first lattice plate 310 including a first portion 311 disposed to support the second display area A2 and a second portion 312 disposed to support the third area A3 and supported by the multi-bar structure 360.

According to an embodiment, the flexible lattice plate 305 may include a second lattice plate 320 stacked on the first lattice plate 310, a third lattice plate 330 stacked on the second lattice plate 320, and a fourth lattice plate 340 stacked on the third lattice plate 330.

According to an embodiment, the second lattice plate 320 may include a cover portion 321 surrounding an edge of the third lattice plate 330.

According to an embodiment, the first lattice plate 310 may include a first pattern 313 including at least one hole or groove, and the second lattice plate 320 may include a second pattern 323 including at least one hole or groove.

According to an embodiment, the first pattern 313 may not overlap the second pattern 323.

According to an embodiment, the fourth lattice plate 340 may include a protruding portion 345, and the protruding portion 345 may protrude further than other portions of the fourth lattice plate 340.

According to an embodiment, the electronic device 101 may include a first head 371 coupled to the first portion 311 of the first lattice plate 310 and the fourth lattice plate 340.

According to an embodiment, the electronic device 101 may include a second head 372 coupled to the second portion 312 of the first lattice plate 310 and the multi-bar structure 360.

According to an embodiment, the electronic device 101 may include a block 390 coupled to the third lattice plate 330 and the first head 371.

According to an embodiment, the block 390 may include a first insertion portion 392 inserted between the third lattice plate 330 and the first head 371.

According to an embodiment, the block 390 may include a second insertion portion 393 inserted into a first accommodating portion 337 formed in the third lattice plate 330.

According to an embodiment, the block 390 may include a third insertion portion 394 inserted into a second accommodating portion 377 formed in the first head 371.

According to an embodiment, the electronic device 101 may further include a buffer member 380 disposed between the multiple lattice layers.

According to an embodiment, the electronic device 101 may further include an adhesive member 350 disposed between the second portion 312 of the first lattice plate 310 and the multi-bar structure 360.

According to an embodiment of the disclosure, an electronic device 101 may include a housing 210 including a first housing portion 201 and a second housing portion 202 configured to move with respect to the first housing portion 201.

According to an embodiment, the electronic device 101 may include a display 301 including a first display area A1 disposed in the second housing portion 202, a second display area A2 extending from the first display area A1, and a third area A3 extending from the second display area A2.

According to an embodiment, the electronic device 101 may include a first lattice plate 310 configured to support the second display area A2 and the third area A3, a second lattice plate 320 configured to support a first portion 311 of the first lattice plate 310 corresponding to the second display area A2, a third lattice plate 330 stacked on the second lattice plate 320, and a fourth lattice plate 340 stacked on the third lattice plate 330.

According to an embodiment, the electronic device 101 may include a multi-bar structure 360 supporting a second portion 312 of the first lattice plate 310 corresponding to the third area A3.

According to an embodiment, each of the first lattice plate 310, the second lattice plate 320, the third lattice plate 330, and the fourth lattice plate 340 may include a pattern 313, 323, 333, or 343 including at least one hole or groove.

According to an embodiment, the second lattice plate 320 may include a cover portion 321 surrounding an edge of the third lattice plate 330.

According to an embodiment, the electronic device 101 may further include an adhesive member 350 disposed between the second portion 312 of the first lattice plate 310 and the multi-bar structure 360.

According to an embodiment, the electronic device 101 may include a first buffer member 381 disposed between the first lattice plate 310 and the second lattice plate 320, a second buffer member 382 disposed between the second lattice plate 320 and the third lattice plate 330, and a third buffer member 383 disposed between the third lattice plate 330 and the fourth lattice plate 340.

Although specific embodiments have been described above in the detailed description of the disclosure, it will be apparent to those ordinarily skilled in the art that various modifications may be made without departing from the scope of the disclosure.

## Claims

1. An electronic device (101) comprising:
a housing (210) including a first housing portion (201) and a second housing portion (202) configured to move with respect to the first housing portion (201);
a display (301) including a first display area (A1), a second display area (A2), and a third area (A3);
a flexible lattice plate (305) disposed to support the second display area (A2) and the third area (A3) of the display (301); and
a multi-bar structure (360) disposed to support at least a portion of the flexible lattice plate (305) corresponding to the third area (A3) of the display (301),
wherein another portion of the flexible lattice plate (305) supporting the second display area (A2) of the display (301) includes multiple lattice layers.

2. The electronic device of claim 1, wherein each of the multiple lattice layers includes a lattice pattern (313, 323, 333, 343) including elongated holes and/or elongated grooves.

3. The electronic device of any one of claims 1 to 2, wherein the third area (A3) of the display (301) has no pixel elements.

4. The electronic device of any one of claims 1 to 3, wherein the second display area (A2) of the display (301) corresponding to the multiple lattice layers is configured not to be visually exposed to a front side of the housing (210) when the second housing portion (202) is located in a first position with respect to the first housing portion (201), and
wherein the second display area (A2) of the display (301) corresponding to the multiple lattice layers is configured to be visually exposed to the front side of the housing (201) when the second housing portion (202) is located in a second position different from the first position with respect to the first housing portion (201).

5. The electronic device of any one of claims 1 to 4, wherein the third area (A3) corresponding to the multi-bar structure (360) is configured to be not visually exposed to the front side of the housing (210) when the second housing portion (202) is located in the first position or the second position with respect to the first housing portion (201), and
wherein the first display area (A1) is configured to be visually exposed to the front side of the housing (210) when the second housing portion (202) is located in the first position or the second position with respect to the first housing portion (201).

6. The electronic device of any one of claims 1 to 5, wherein the flexible lattice plate (305) includes:
a first lattice plate (310) including a first portion (311) disposed to support the second display area (A2) and a second portion (312) disposed to support the third area (A3) and supported by the multi-bar structure (360);
a second lattice plate (320) stacked on the first lattice plate (310);
a third lattice plate (330) stacked on the second lattice plate (320); and
a fourth lattice plate (340) stacked on the third lattice plate (330).

7. The electronic device of any one of claims 1 to 6, wherein the second lattice plate (320) includes a cover portion (321) surrounding an edge of the third lattice plate (330).

8. The electronic device of any one of claims 1 to 7, wherein the first lattice plate (310) includes a first pattern (313) including at least one hole or groove, and
wherein the second lattice plate (320) includes a second pattern (323) including at least one hole or groove.

9. The electronic device of any one of claims 1 to 8, wherein the first pattern (313) does not overlap the second pattern (323).

10. The electronic device of any one of claims 1 to 9, wherein the fourth lattice plate (340) includes a protruding portion (345), and
wherein the protruding portion (345) protrudes more than other portions of the fourth lattice plate (340).

11. The electronic device of any one of claims 1 to 10, further comprising:
a first head (371) coupled to the first portion (311) of the first lattice plate (310) and the fourth lattice plate (340); and
a second head (372) coupled to the second portion (312) of the first lattice plate (310) and the multi-bar structure (360).

12. The electronic device of any one of claims 1 to 11, further comprising:
a block (390) coupled to the third lattice plate (330) and the first head (371).

13. The electronic device of any one of claims 1 to 12, wherein the block (390) includes:
a first insertion portion (392) inserted between the third lattice plate (330) and the first head (371);
a second insertion portion (393) inserted in a first accommodating portion (327) formed in the third lattice plate (330); and
a third insertion portion (394) inserted in a second accommodating portion (377) formed in the first head (371).

14. The electronic device of any one of claims 1 to 13, further comprising:
a buffer member (380) disposed between the multiple lattice layers.

15. The electronic device of any one of claims 1 to 14, further comprising:
an adhesive member (350) disposed between the second portion (312) of the first lattice plate (310) and the multi-bar structure (360).
